(19) **Europäisches Patentamt / European Patent Office / Office européen des brevets**

(11) **EP 4 492 423 B1**

(12) **FASCICULE DE BREVET EUROPEEN**

(45) Date de publication et mention de la délivrance du brevet:
**18.03.2026 Bulletin 2026/12**

(21) Numéro de dépôt: **24186904.9**

(22) Date de dépôt: **05.07.2024**

(51) Classification Internationale des Brevets (IPC):
*H01H 47/00* *(2006.01)*

(52) Classification Coopérative des Brevets (CPC):
**H01H 47/002;** H01H 3/3031; H01H 3/3052;
H01H 71/2463; H01H 2071/044

(54) **PROCÉDÉ DE DÉTECTION D'UNE DÉGRADATION D'UN APPAREIL DE COMMUTATION**

VERFAHREN ZUR ERKENNUNG EINER VERSCHLECHTERUNG EINER SCHALTVORRICHTUNG

METHOD FOR DETECTING A DEGRADATION OF A SWITCHING DEVICE

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR

(30) Priorité: **13.07.2023 FR 2307587**

(43) Date de publication de la demande:
**15.01.2025 Bulletin 2025/03**

(73) Titulaire: **SCHNEIDER ELECTRIC INDUSTRIES SAS**
**92500 Rueil-Malmaison (FR)**

(72) Inventeurs:
• **MELEY, Jean-Pierre**
38330 ST ISMIER (FR)
• **EL KHOURY, Diana**
38000 GRENOBLE (FR)

(74) Mandataire: **Plasseraud IP**
**104 Rue de Richelieu**
**CS92104**
**75080 Paris Cedex 02 (FR)**

(56) Documents cités:
**US-A1- 2017 287 666**     **US-A1- 2023 025 832**
**US-B2- 7 692 522**

Remarques:
PARTIES MANQUANTES OU CORRECTES INCORPORÉES AU TITRE DE LA RÈGLE 56(3) OU DE LA RÈGLE 56bis(4) CBE

## Description

### Domaine technique

La présente invention se rapporte au domaine des appareils de commutation pour équipements électriques, par exemple pour des équipements électriques de basse et moyenne tension. L'appareil de commutation peut par exemple être un disjoncteur.

### Technique antérieure

Un appareil de commutation basse ou moyenne tension peut comprendre un ou plusieurs actionneurs, par exemple de type électromagnétique, permettant de déclencher l'ouverture d'un circuit électrique. Pour cela, l'actionneur peut déverrouiller un mécanisme de commande à ressort, permettant de déplacer un contact électrique mobile, de façon à ouvrir ou fermer le circuit électrique. Dans le cas d'un disjoncteur, l'ouverture du circuit électrique est réalisée en cas d'apparition d'un défaut dans le circuit électrique. Le défaut peut être par exemple un court-circuit entre deux phases, ou entre une phase et la terre.

Lorsque l'actionneur est de type électromagnétique, celui-ci comprend un noyau magnétique mobile et une bobine de commande. Sous l'action d'un courant électrique parcourant la bobine de commande, le noyau magnétique se déplace. Le noyau magnétique est mécaniquement couplé à un élément d'entrainement agissant sur les contacts électriques mobiles de façon à pouvoir ouvrir ou fermer le circuit électrique. La fermeture du circuit permet la mise sous-tension d'une charge.

Afin d'assurer la sécurité du réseau électrique et des personnes, il est important de pouvoir vérifier le bon fonctionnement des appareils de commutation tout au long de leur durée de vie. Un appareil de commutation est généralement soumis aux effets d'un vieillissement qui peut dégrader progressivement ses fonctions électriques ou mécaniques, et à terme le rendre inopérant. Il est donc important pour les utilisateurs de pouvoir suivre l'évolution de l'état de l'appareil de commutation. En particulier, il est souhaitable de pouvoir suivre l'état du mécanisme de commande entre l'actionneur et les contacts mobiles, et en particulier de pouvoir détecter une dégradation de ce mécanisme de commande. Le document US 7 692 522 B2 est un exemple d'un tel procédé de détection. Les utilisateurs peuvent ainsi intervenir pour réparer ou changer le mécanisme de commande à un moment opportun dans la gestion du réseau électrique.

### Résumé

A cette fin, l'invention propose un procédé de détection d'une dégradation d'un appareil de commutation comprenant :

- un contact électrique mobile entre une position de fermeture d'un circuit électrique et une position d'ouverture du circuit électrique,
- un mécanisme de commande comprenant :

  -- un élément d'entrainement configuré pour déplacer le contact électrique mobile de façon à ouvrir un circuit électrique,
  -- un organe élastique lié à l'élément d'entrainement,
  -- un organe de déverrouillage configuré pour passer d'une position de verrouillage dans laquelle l'organe élastique est maintenu dans un état de tension à une position de libération dans laquelle l'organe élastique est libre de se détendre de façon à déplacer le contact électrique de la position de fermeture à la position d'ouverture du circuit électrique, ou de la position d'ouverture à la position de fermeture,

- un actionneur configuré pour déplacer l'organe de déverrouillage de la position de verrouillage à la position de libération,

le procédé comportant les étapes :

  (i) commander l'actionneur de façon à déplacer l'organe de déverrouillage de la position de verrouillage à la position de libération,
  (ii) déterminer un premier instant correspondant à une position prédéterminée de l'organe de déverrouillage,
  (iii) déterminer un deuxième instant correspondant à une position prédéterminée de l'élément d'entrainement,
  (iv) déterminer une durée écoulée entre le premier instant et le deuxième instant,
  (v) itérer les étapes (i) à (iii) pour un ensemble de commandes successives de l'actionneur, de façon à obtenir un ensemble de valeurs de la durée écoulée entre le premier instant et le deuxième instant,

commutation à partir de l'évolution des valeurs de l'ensemble au cours des commandes successives de l'actionneur.

Le procédé de détection d'une dégradation de l'appareil de commutation est un procédé permettant de détecter une évolution du comportement du mécanisme de commande de l'appareil de commutation en raison du vieillissement de ses composants. Le vieillissement des composants comprend par exemple l'usure, les déformations, l'effet de la corrosion, l'évolution des propriétés tribologiques des composants.

La durée écoulée entre le premier instant et le deuxième instant correspond à un temps de réaction de l'organe de déverrouillage. Le suivi de l'évolution de la valeur de la durée, c'est-à-dire comment la durée évolue au cours de la vie de l'appareil de commutation, permet de suivre l'évolution du comportement du mécanisme de commande de l'appareil de commutation au cours de son utilisation.

Dans le cas où l'organe de déverrouillage fonctionne de façon nominale, les valeurs de l'ensemble n'évoluent sensiblement pas au cours des actionnements successifs de l'appareil de commutation. Autrement dit, les différentes valeurs de l'ensemble sont sensiblement constantes. A l'inverse, une dégradation progressive du mécanisme de commande a tendance à provoquer une évolution des valeurs au cours des actionnements successifs, en particulier une fluctuation de ces valeurs. Les valeurs de l'ensemble ne sont plus sensiblement constantes et présentent une fluctuation significative. Cette évolution progressive permet de détecter une dégradation de l'organe de déverrouillage.

Le procédé de détection d'une dégradation de l'appareil de commutation est un procédé permettant également de d'anticiper l'apparition d'un défaut de l'appareil de commutation.

En effet, une dégradation non corrigée de l'appareil de commutation peut conduire à terme à l'apparition d'un défaut, et ce défaut peut ainsi être anticipé.

Les caractéristiques listées dans les paragraphes suivant peuvent être mises en œuvre indépendamment les unes des autres ou selon toutes les combinaisons techniquement possibles :

A l'étape (vii), l'évolution des valeurs de l'ensemble peut être une fluctuation des valeurs de l'ensemble au cours des commandes successives de l'actionneur électromagnétique.

Selon un mode de réalisation, le contact électrique est mobile entre une position de fermeture d'un circuit électrique et une position d'ouverture du circuit électrique, et une détente de l'organe élastique déplace le contact électrique de la position de fermeture à la position d'ouverture du circuit électrique.

Le mécanisme de commande permet ainsi d'interrompre la circulation du courant électrique dans le circuit.

Selon un autre mode de réalisation, le contact électrique est mobile entre une position d'ouverture d'un circuit électrique et une position de fermeture du circuit électrique, et

une détente de l'organe élastique déplace le contact électrique de la position d'ouverture à la position de fermeture du circuit électrique.

Le mécanisme de commande permet ainsi d'établir une circulation du courant électrique dans le circuit.

L'ensemble de valeurs de la durée écoulée entre le premier instant et le deuxième instant est obtenu par une succession d'actionnements consécutifs de l'appareil de commutation.

Chaque valeur de l'ensemble de valeurs de la durée écoulée entre le premier instant et le deuxième instant correspond à un actionnement distinct de l'appareil de commutation.

Chaque actionnement de l'appareil de commutation correspond à une commande de l'actionneur.

L'appareil de commutation peut être un disjoncteur.

L'appareil de commutation peut être un interrupteur.

L'appareil de commutation peut être un sectionneur.

Selon un mode de réalisation, l'actionneur est un actionneur électromagnétique.

L'actionneur électromagnétique comprend un électroaimant.

L'actionneur électromagnétique comprend une bobine de commande et un noyau magnétique configuré pour se déplacer sous l'action d'un champ magnétique créé par une circulation de courant électrique dans la bobine de commande.

Le noyau magnétique est par exemple mobile en translation.

L'organe de déverrouillage est lié à un noyau magnétique de l'actionneur électromagnétique.

Selon un autre mode de réalisation, l'actionneur comprend un bouton-poussoir actionnable manuellement par un opérateur.

L'organe de déverrouillage comprend un indicateur de position.

L'indicateur de position fournit un signal à deux niveaux.

L'indicateur de position est un contacteur à deux états électriques.

La position prédéterminée de l'organe de déverrouillage permettant de déterminer le premier instant peut être une position d'équilibre de l'organe de déverrouillage.

La position prédéterminée de l'organe de déverrouillage permettant de déterminer le premier instant peut être une position transitoire de l'organe de déverrouillage.

La position prédéterminée de l'élément d'entrainement permettant de déterminer le deuxième instant peut être une position transitoire de l'élément d'entrainement.

L'organe élastique est configuré pour appliquer une force d'entrainement sur le contact électrique.

L'organe élastique peut être un ressort, par exemple un ressort spiral ou un ressort hélicoïdal.

L'élément d'entrainement peut être mobile en rotation.

L'élément d'entrainement peut être relié au contact mobile par une biellette de liaison.

On entend par mesurer un courant circulant dans l'actionneur électromagnétique le fait de mesurer l'intensité du courant électrique circulant dans l'actionneur électromagnétique.

Le courant circulant dans l'actionneur électromagnétique peut être détecté par un capteur de mesure du courant circulant dans l'actionneur électromagnétique.

Le courant circulant dans l'actionneur électromagnétique peut être échantillonné, par exemple avec une fréquence d'échantillonnage comprise entre 1 kHz et 100 kHz.

L'actionneur est configuré pour déclencher un déplacement du contact électrique mobile afin d'ouvrir ou fermer le circuit électrique.

Lorsque l'appareil de commutation est un disjoncteur, l'actionneur électromagnétique est configuré pour déclencher une ouverture du circuit électrique en cas de présence d'un défaut sur le circuit électrique.

Selon un mode de réalisation du procédé de détection proposé, dans lequel l'actionneur est un actionneur électromagnétique, le procédé comprend les sous-étapes :

- mesurer un courant circulant dans l'actionneur électromagnétique lors de l'actionnement de l'appareil de commutation,
- déterminer le premier instant correspondant à une position prédéterminée de l'organe de déverrouillage à partir des variations temporelles du courant mesuré.

Le procédé proposé ne demande ainsi l'installation d'aucun capteur supplémentaire, tel un capteur de déplacement du contact électrique ou un capteur du déplacement d'un élément du mécanisme d'actionnement.

Le procédé proposé comprend une sous-étape de détermination des variations temporelles du courant mesuré.

L'actionneur électromagnétique comprend une bobine de commande et un noyau magnétique configuré pour se déplacer sous l'action d'un champ magnétique créé par une circulation de courant électrique dans la bobine de commande.

La position prédéterminée de l'organe de déverrouillage correspondant au premier instant est une position de déplacement maximal du noyau magnétique.

Selon un aspect du procédé de détection, le premier instant correspondant à une position prédéterminée de l'organe de déverrouillage est un instant correspondant à une valeur minimale locale du courant électrique circulant dans l'actionneur électromagnétique.

Le premier instant peut être déterminé à partir de l'évolution temporelle de l'intensité du courant circulant dans la bobine de commande, et coïncide avec l'instant où le courant passe par une valeur minimale locale.

Selon un autre mode de réalisation du procédé de détection proposé, dans lequel l'actionneur comprend un bouton-poussoir actionnable manuellement par un opérateur et dans lequel l'organe de déverrouillage comprend un indicateur de position, le procédé comprend les sous-étapes :

- mesurer un signal électrique de l'indicateur de position,
- déterminer le premier instant correspondant à une position prédéterminée de l'organe de déverrouillage à partir des variations temporelles du signal électrique de l'indicateur de position.

L'instant correspond à un changement d'état électrique de l'indicateur de position.

L'instant est une référence temporelle indiquant que l'action exercée sur le bouton poussoir a bien été transmise à l'organe de déverrouillage.

Selon un mode de réalisation du procédé de détection, la position prédéterminée de l'élément d'entrainement correspondant au deuxième instant est une position intermédiaire de déplacement de l'élément d'entrainement. La position intermédiaire de déplacement est comprise entre une première position extrême dans laquelle le contact électrique mobile est en position fermée et une deuxième position extrême dans laquelle le contact électrique mobile est en position ouverte.

Une course angulaire de déplacement de l'élément d'entrainement est par exemple comprise entre 40° et 60°.

Selon un mode de réalisation du procédé de détection, une course de déplacement de l'élément d'entrainement entre la première position extrême et la position prédéterminée correspondant au deuxième instant est comprise entre 5% et 15% d'une course de déplacement totale de l'élément d'entrainement.

La partie initiale de la course de déplacement de l'élément d'entrainement est ainsi utilisée pour déterminer le deuxième instant servant de référence. La sensibilité de détection du procédé proposé est ainsi améliorée.

Le procédé de détection peut comprendre les sous-étapes :

- mesurer une position de l'élément d'entrainement lors de l'actionnement de l'appareil de commutation,
- déterminer le deuxième instant correspondant à la position prédéterminée de l'élément d'entrainement à partir de la position mesurée de l'élément d'entrainement.

Selon un mode de réalisation du procédé de détection proposé :

- le mécanisme de commande comprend un capteur de position configuré pour détecter un champ magnétique,
- l'élément d'entrainement comprend une pluralité d'éléments magnétiques configurés pour passer successivement devant le capteur de position lors d'une course de déplacement de l'élément d'entrainement.

Les éléments magnétiques peuvent être des aimants permanents.

Le capteur de position peut être un capteur à effet Hall.

Les éléments magnétiques sont par exemple disposés sur une partie d'une périphérie de l'élément d'entrainement.

Les éléments magnétiques peuvent être disposés dans un plan perpendiculaire à un axe de rotation de l'élément d'entrainement.

Les éléments magnétiques peuvent être identiques.

Un écart angulaire entre deux éléments magnétiques consécutifs peut être constant.

L'élément d'entrainement comprend par exemple quatre éléments magnétiques.

Selon un mode de réalisation, l'organe de déverrouillage comprend une demi-lune mobile en rotation.

La demi-lune est actionnée par le noyau magnétique de l'actionneur électromagnétique.

L'organe de déverrouillage peut comprendre un levier intermédiaire comprenant une première portion configurée pour coopérer avec la demi-lune et comprenant une deuxième portion configurée pour coopérer avec l'élément d'entrainement.

Selon un mode de réalisation, le procédé de détection comprend la sous-étape :

- calculer une valeur d'un paramètre statistique représentatif d'une fluctuation des valeurs de l'ensemble de valeurs de la durée écoulée entre le premier instant et le deuxième instant,
- déterminer une dégradation de l'organe de déverrouillage à partir de la valeur calculée du paramètre statistique.

Selon un exemple de mise en œuvre du procédé de détection, le paramètre statistique représentatif d'une fluctuation des valeurs de l'ensemble de valeurs de la durée écoulée entre le premier instant et le deuxième instant comprend une différence entre :

- une valeur courante de la durée écoulée entre le premier instant et le deuxième instant, déterminée pour un actionnement courant de l'appareil de commutation, et
- une valeur moyenne des valeurs de la durée écoulée entre le premier instant et le deuxième instant obtenues pour un nombre prédéterminé d'actionnements précédant l'actionnement courant de l'appareil de commutation.

La valeur moyenne peut être une moyenne glissante calculée à partir des valeurs correspondant aux actionnements précédent l'actionnement courant, et comprenant un nombre de valeurs égal au nombre prédéterminé d'actionnements.

Selon un exemple de mise en œuvre du procédé de détection, le paramètre statistique représentatif d'une fluctuation des valeurs de l'ensemble de valeurs de la durée écoulée entre le premier instant et le deuxième instant comprend un écart-type des valeurs de la durée écoulée entre le premier instant et le deuxième instant déterminé pour un ensemble d'actionnements de l'appareil de commutation réalisés dans des conditions de référence correspondant à un état neuf du disjoncteur.

L'ensemble d'actionnements de l'appareil de commutation réalisés dans des conditions de référence comprend par exemple 20 actionnements successifs de l'appareil de commutation.

Le procédé proposé comprend ainsi une phase de calibration permettant de quantifier les variations nominales de la valeur de la durée écoulée entre le premier instant et le deuxième instant lors de l'actionnement de l'appareil de commutation. Ces variations nominales correspondent aux variations observées dans un état de référence dans lequel l'appareil de commutation ne présente ni défaut de montage ni dégradation due à l'usure.

L'état de référence correspond par exemple à un état neuf de l'appareil de commutation.

Le procédé proposé comprend une phase de mesure dans laquelle les variations de la valeur de la durée écoulée entre le premier instant et le deuxième instant sont analysées.

La phase de mesure suit la phase de calibration.

La phase de mesure est réalisée tout au long de la durée d'utilisation de l'appareil de commutation.

Selon un exemple de mise en œuvre du procédé de détection proposé, le paramètre statistique représentatif d'une fluctuation de la durée écoulée entre le premier instant et le deuxième instant est égal au rapport de :

- la différence entre une valeur courante de la durée écoulée entre le premier instant et le deuxième instant et la valeur moyenne des valeurs de la durée écoulée entre le premier instant et le deuxième instant obtenues pour un nombre prédéterminé d'actionnements précédant l'actionnement courant, et de
- l'écart-type des valeurs de la durée écoulée entre le premier instant et le deuxième instant déterminé pour un ensemble d'actionnements de l'appareil de commutation réalisés dans des conditions de référence correspondant à un état neuf de l'appareil de commutation.

Le paramètre statistique proposé permet une détection robuste d'une éventuelle dégradation de l'organe de déverrouillage de l'appareil de commutation, tout en étant simple à mettre en œuvre. En particulier, les calculs nécessaires sont facilement réalisables en temps réel, ce qui permet une détection rapide d'une dégradation.

Le paramètre statistique représentatif d'une fluctuation de la durée écoulée entre le premier instant et le deuxième instant peut ainsi être égal à :

[Math. 1]

$$P(i) = \frac{D_i - \frac{\sum_{j=i-M}^{j=i-1} D_j}{M}}{\sqrt{\sum_{j=1}^{N} \left(\frac{D_j - \frac{\sum_{j=1}^{j=N} D_j}{K}}{K}\right)^2}}$$

Avec $D_i$ la valeur déterminée de la durée D pour un actionnement de rang i,

P(i) la valeur calculée du paramètre statistique P pour l'actionnement de rang i,
M le nombre d'actionnements pris en compte pour déterminer une valeur moyenne,
K un nombre d'actionnements réalisés dans des conditions de référence correspondant à un état neuf de l'appareil de commutation.

Selon un aspect du procédé de détection proposé, une dégradation de l'organe de déverrouillage est déterminée lorsque la valeur absolue du paramètre statistique représentatif d'une fluctuation de la durée écoulée entre le premier instant et le deuxième instant est supérieure à un premier seuil prédéterminé positif.

La valeur choisie pour le premier seuil prédéterminé permet d'ajuster la sensibilité du procédé de détection proposé.

Le premier seuil prédéterminé est par exemple compris entre 2 et 3.

Selon un exemple de réalisation du procédé de détection, la dégradation de l'organe de déverrouillage est classifiée en un premier type de dégradation, dit dégradation mineure, lorsque la valeur absolue du paramètre statistique représentatif d'une fluctuation de la durée écoulée entre le premier instant et le deuxième instant est supérieure à un premier seuil prédéterminé positif et inférieure à un deuxième seuil prédéterminé positif.

Le deuxième seuil prédéterminé est par exemple compris entre 4 et 5.

Selon un exemple de réalisation du procédé de détection, la dégradation de l'organe de déverrouillage est classifiée en un deuxième type de dégradation, dit dégradation majeure, lorsque le critère représentatif d'une fluctuation de la durée écoulée entre le premier instant et le deuxième instant est supérieur au deuxième seuil prédéterminé.

Le paramètre statistique P utilisé permet ainsi une quantification de la dégradation, et non uniquement la présence ou l'absence de dégradation.

Le procédé de détection peut comprendre une étape d'émission d'un signal d'alerte en réponse à une détermination d'une dégradation de l'organe de déverrouillage.

Le signal d'alerte émis permet aux utilisateurs de planifier et de réaliser une opération de maintenance ou de remplacement de l'appareil de commutation.

Aucun signal d'alerte n'est émis lorsqu'aucune dégradation n'a été déterminée. Autrement dit, aucune alerte n'est émise lorsque le procédé proposé indique que l'organe de déverrouillage est exempt de dégradation.

L'invention se rapporte également à un appareil de commutation comprenant :

- un contact électrique mobile entre une position de fermeture d'un circuit électrique et une position d'ouverture du circuit électrique,
- un mécanisme de commande comprenant :

-- un élément d'entrainement configuré pour déplacer le contact électrique mobile de façon à ouvrir un circuit électrique,
-- un organe élastique lié à l'élément d'entrainement,
-- un organe de déverrouillage configuré pour passer d'une position de verrouillage dans laquelle l'organe élastique est maintenu dans un état de tension à une position de libération dans laquelle l'organe élastique est libre de se détendre de façon à déplacer le contact électrique de la position de fermeture à la position d'ouverture du circuit électrique,

- un actionneur configuré pour déplacer l'organe de déverrouillage de la position de verrouillage à la position de libération,
- une unité électronique de contrôle configurée pour mettre en œuvre le procédé de détection de dégradation tel que décrit précédemment.

L'appareil de commutation peut être un disjoncteur, ou un interrupteur, ou un sectionneur.

**Brève description des dessins**

D'autres caractéristiques, détails et avantages apparaîtront à la lecture de la description détaillée ci-après, et à l'analyse des dessins annexés, sur lesquels :

[Fig. 1] est une vue schématique d'un circuit électrique équipé d'un appareil de commutation, le circuit électrique étant en position fermée,

[Fig. 2] est une vue schématique d'un circuit électrique équipé d'un appareil de commutation, le circuit électrique étant en position ouverte,

[Fig. 3] est une vue schématique du mécanisme de commande d'un appareil de commutation selon un premier mode de réalisation, le circuit électrique étant en position fermée,

[Fig. 4] est une vue schématique du mécanisme de commande de l'appareil de commutation de la figure 3, le circuit électrique étant en position ouverte,

[Fig. 5] illustre l'évolution temporelle de plusieurs paramètres de fonctionnement de l'appareil de commutation des figures 3 et 4, lors de l'actionnement de celui-ci,

[Fig. 6] est un schéma temporel illustrant le procédé selon l'invention,

[Fig. 7] est un schéma-bloc illustrant différentes étapes du procédé selon l'invention,

[Fig. 8] est une vue schématique du mécanisme de commande d'un appareil de commutation selon un deuxième mode de réalisation, le circuit électrique étant en position fermée,

[Fig. 9] est une vue schématique du mécanisme de commande de l'appareil de commutation de la figure 7, le circuit électrique étant en position ouverte.

**Description des modes de réalisation** :

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un sous-système comporte un élément donné, cela n'exclut pas la présence d'autres éléments dans ce sous-système. De même, quand il est précisé qu'un sous-système comprend un élément donné, il est entendu que le sous-système comprend au moins cet élément.

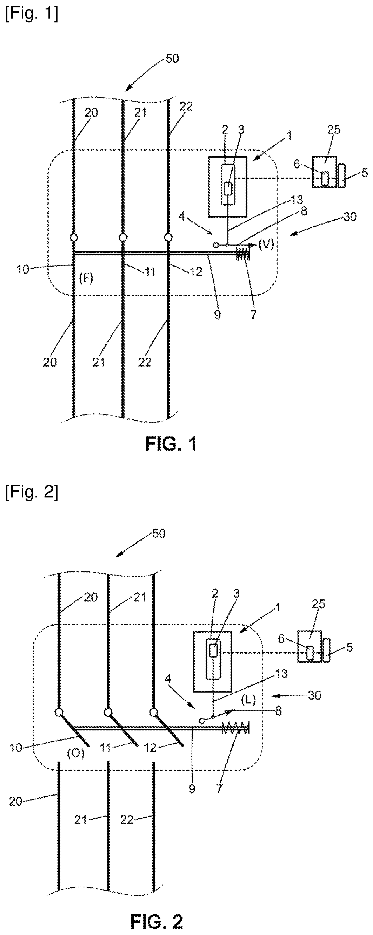

On a représenté schématiquement sur la figure 1 un circuit électrique 50. Le circuit électrique 50 comporte trois conducteurs électriques 20, 21, 22, chaque conducteur correspondant à une phase d'un réseau triphasé moyenne tension.

Le circuit électrique 50 comprend un appareil de commutation 30.

L'appareil de commutation 30 peut être un disjoncteur. En variante, l'appareil de commutation 30 peut être un interrupteur. Selon un autre exemple d'application, l'appareil de commutation 30 peut être un sectionneur.

La figure 1 et la figure 2 illustrent respectivement, de manière schématique, deux états de l'appareil de commutation 30.

L'appareil de commutation 30 comprend un contact électrique 10 mobile entre une position de fermeture F d'un circuit électrique 50 et une position d'ouverture O du circuit électrique 50.

L'appareil de commutation 30 comprend aussi un mécanisme de commande 4 comprenant :

- un élément d'entrainement 9 configuré pour déplacer le contact électrique mobile 10 de façon à ouvrir un circuit électrique 50,
- un organe élastique 7 lié à l'élément d'entrainement 9,
- un organe de déverrouillage 8 configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position de fermeture F à la position d'ouverture O du circuit électrique 50.

L'appareil de commutation 30 comprend en outre un actionneur 1 configuré pour déplacer l'organe de déverrouillage 8 de la position de verrouillage V à la position de libération L.

L'appareil de commutation 30 comprend également une unité électronique de contrôle 25 configurée pour mettre en œuvre le procédé de détection de dégradation qui va être décrit en détail ci-dessous.

L'organe élastique 7 est configuré pour appliquer une force d'entrainement sur le contact électrique 10. L'organe élastique 7 peut être un ressort, par exemple un ressort spiral ou un ressort hélicoïdal.

L'actionneur 1 est configuré pour déclencher un déplacement du contact électrique mobile 10 afin d'ouvrir ou fermer le circuit électrique 50.

En effet, l'actionneur 1 permet de déverrouiller le mécanisme de commande 4 afin de réaliser un déplacement du contact mobile 10 et ainsi une ouverture du circuit électrique 50, ou une fermeture.

Sur la figure 1, les contacts mobiles 10, 11, 12 sont en position fermée, c'est-à-dire qu'un courant électrique peut circuler dans le circuit électrique 50. Le signe F indique la position fermée du contact mobile 10.

L'organe élastique 7 est à l'état tendu. L'organe élastique 7 est maintenu à l'état tendu par l'organe de déverrouillage 8. L'élément d'entrainement 9 est bloqué par l'organe de déverrouillage 8.

L'ouverture du circuit électrique 50 est réalisée de la manière suivante :

Sous l'action de l'actionneur 1, l'organe de déverrouillage 8 est déplacé dans une position de libération L dans laquelle l'élément d'entrainement 9 n'est plus bloqué par l'organe de déverrouillage 8. L'élément d'entrainement 9 peut se déplacer sous l'action de la force d'entrainement appliquée par l'organe élastique 7, qui était dans un état tendu et qui est libre de se détendre. L'élément d'entrainement 9 déplace ainsi le contact électrique 10 de la position de fermeture F à la position d'ouverture O du circuit électrique 50.

Les trois contacts mobiles 10, 11, 12 sont couplés mécaniquement, de sorte que les trois contacts 10, 11, 12 passent conjointement en position d'ouverture lorsque le mécanisme de commande 4 est déverrouillé.

La figure 2 schématise la position des différents éléments une fois que les contacts mobiles 10, 11, 12 ont été déplacés en position d'ouverture du circuit électrique 50.

Selon le mode de réalisation illustré sur la figure 1 et la figure 2, l'actionneur 1 est un actionneur électromagnétique.

L'actionneur électromagnétique 1 comprend un électroaimant.

L'actionneur électromagnétique 1 comprend une bobine de commande 2 et un noyau magnétique 3 configuré pour se déplacer sous l'action d'un champ magnétique créé par une circulation de courant électrique dans la bobine de commande 2.

Le noyau magnétique 3 est par exemple mobile en translation.

L'organe de déverrouillage 8 est lié au noyau magnétique 3 de l'actionneur électromagnétique 1.

Un déplacement du noyau magnétique 3 de l'actionneur électromagnétique 1 provoque donc un déplacement de l'organe de déverrouillage 8.

Lorsque l'appareil de commutation 30 est un disjoncteur, l'actionneur électromagnétique 1 est configuré pour déclencher une ouverture du circuit électrique 50 en cas de présence d'un défaut sur le circuit électrique 50.

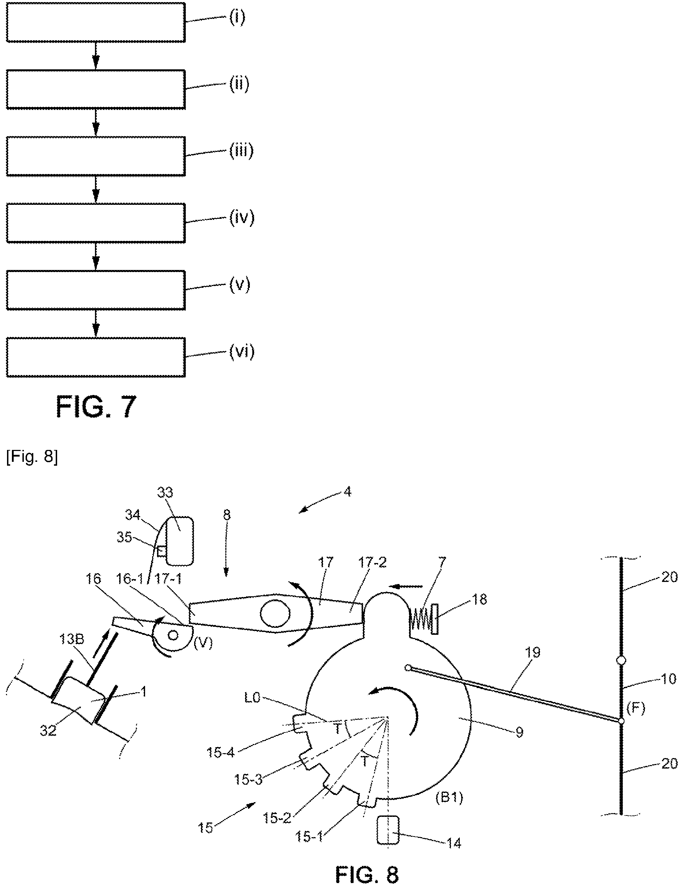

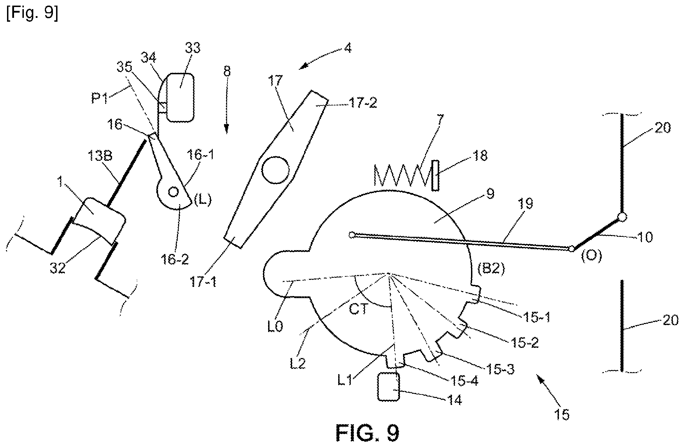

Selon un autre mode de réalisation, illustré sur les figures 8 et 9, l'actionneur 1 comprend un bouton-poussoir 32 actionnable manuellement par un opérateur.

Lorsque l'opérateur souhaite déclencher une ouverture du circuit électrique 50, l'opérateur presse le bouton poussoir 32, qui est mécaniquement lié à l'organe de déverrouillage 8. L'organe de déverrouillage 8 est ainsi déverrouillé par l'action de l'opérateur sur le bouton poussoir 32.

Dans ce mode de réalisation, l'organe de déverrouillage 8 comprend un indicateur de position 33.

Le procédé proposé vise à détecter une dégradation de l'appareil de commutation 30, c'est-à-dire détecter une évolution du comportement du mécanisme de commande 4 de l'appareil de commutation 30, et en particulier de l'organe de déverrouillage 8, en raison du vieillissement de ses composants. Le vieillissement des composants comprend par exemple l'usure, les déformations, l'évolution des performances magnétiques, l'évolution des propriétés tribologiques des composants.

Il est ainsi proposé un procédé de détection d'une dégradation d'un appareil de commutation 30 comprenant :

- un contact électrique 10 mobile entre une position de fermeture F d'un circuit électrique 50 et une position d'ouverture O du circuit électrique 50,
- un mécanisme de commande 4 comprenant :

  -- un élément d'entrainement 9 configuré pour déplacer le contact électrique mobile 10 de façon à ouvrir un circuit électrique 50,
  -- un organe élastique 7 lié à l'élément d'entrainement 9,
  -- un organe de déverrouillage 8 configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position de fermeture F à la position d'ouverture O du circuit électrique 50, ou de la position d'ouverture O à la position de fermeture F,

- un actionneur 1 configuré pour déplacer l'organe de déverrouillage 8 de la position de verrouillage V à la position de libération L,

le procédé comportant les étapes :

  (i) commander l'actionneur 1,
  (ii) déterminer un premier instant t1 correspondant à une position prédéterminée P1 de l'organe de déverrouillage 8,
  (iii) déterminer un deuxième instant t2 correspondant à une position prédéterminée P2 de l'élément d'entrainement 9,
  (iv) déterminer une durée D écoulée entre le premier instant t1 et le deuxième instant t2,
  (v) itérer les étapes (i) à (iii) pour un ensemble de commandes successives de l'actionneur 1, de façon à obtenir un ensemble E de valeurs de la durée D écoulée entre le premier instant t1 et le deuxième instant t2,
  (vi) déterminer une dégradation de l'organe de déverrouillage 8 de l'appareil de commutation 30 à partir de l'évolution des valeurs de l'ensemble E au cours des commandes successives de l'actionneur 1.

La durée D écoulée entre le premier instant t1 et le deuxième instant t2 correspond à un temps de réaction de l'organe de déverrouillage 8. Le suivi de l'évolution de la valeur de la durée D, c'est-à-dire comment la durée D évolue au cours de la vie de l'appareil de commutation 30, permet de suivre l'évolution du comportement de l'organe de déverrouillage du mécanisme de commande 4 au cours de son utilisation.

Dans le cas où l'organe de déverrouillage du mécanisme de commande 4 fonctionne de façon nominale, les valeurs de l'ensemble E n'évoluent sensiblement pas au cours des actionnements successifs de l'appareil de commutation 30. Autrement dit, les différentes valeurs de l'ensemble E sont sensiblement constantes. A l'inverse, une dégradation progressive de l'organe de déverrouillage du mécanisme de commande 4 au cours de la durée de vie d'utilisation de l'appareil de commutation 30 a tendance à provoquer une évolution des valeurs de l'ensemble E au cours des actionnements successifs, en particulier une fluctuation de ces valeurs. Les valeurs de l'ensemble E ne sont ainsi plus sensiblement constantes, et présentent une évolution significative. Cette évolution progressive permet de détecter une dégradation de l'organe de déverrouillage 8 du mécanisme de commande 4.

Le procédé de détection d'une dégradation de l'appareil de commutation 30 est un procédé permettant également de détecter un défaut de l'appareil de commutation 30.

En effet, une dégradation non corrigée de l'appareil de commutation 30 peut conduire à terme à l'apparition d'un défaut, et ce défaut peut également être détecté.

Le mouvement d'ouverture du contact électrique mobile et le mouvement de fermeture peuvent être réalisés de manière analogue.

Selon un exemple de mise en œuvre, le contact électrique 10 est mobile entre une position de fermeture F du circuit électrique 50 et une position d'ouverture O du circuit électrique 50, et

une détente de l'organe élastique 7 déplace le contact électrique 10 de la position de fermeture F à la position d'ouverture O du circuit électrique 50.

Le mécanisme de commande 4 permet ainsi d'interrompre la circulation du courant électrique dans le circuit 50.

Selon un autre exemple de mise en œuvre, le contact électrique 10 est mobile entre une position d'ouverture O d'un circuit électrique 50 et une position de fermeture F du circuit électrique 50, et

une détente de l'organe élastique 7 déplace le contact électrique 10 de la position d'ouverture O à la position de fermeture F du circuit électrique 50.

Le mécanisme de commande 4 permet ainsi d'établir une circulation du courant électrique dans le circuit 50.

L'ensemble E de valeurs de la durée D écoulée entre le premier instant t1 et le deuxième instant t2 est obtenu par une succession d'actionnements consécutifs de l'appareil de commutation 30.

Chaque valeur de l'ensemble E de valeurs de la durée D écoulée entre le premier instant t1 et le deuxième instant t2 correspond à un actionnement distinct de l'appareil de commutation 30.

Chaque actionnement de l'appareil de commutation 30 correspond à une commande de l'actionneur 1.

On entend par actionnement de l'appareil de commutation 30 un passage du contact électrique 10 de la position de fermeture F du circuit électrique 50 à la position d'ouverture O du circuit électrique 50 en réponse à une commande de l'actionneur 1.

Lorsque l'actionneur 1 est un actionneur électromagnétique, un actionnement de l'appareil de commutation 30 est obtenu en faisant circuler du courant dans la bobine de commande 2.

Lorsque l'actionneur 1 est un bouton poussoir, un actionnement de l'appareil de commutation 30 est obtenu par une pression de l'opérateur sur le bouton poussoir.

La position prédéterminée P1 de l'organe de déverrouillage 8 est une première position caractéristique permettant de définir une première référence temporelle permettant de caractériser le fonctionnement du mécanisme de commande 4.

La position prédéterminée P2 de l'élément d'entrainement 9 est une deuxième position caractéristique permettant de définir une deuxième référence temporelle permettant de caractériser le fonctionnement du mécanisme de commande 4.

Plus précisément, la durée séparant ces deux références temporelles peut être un paramètre permettant de déterminer une dégradation du mécanisme de commande 4 de l'appareil de commutation 30.

Selon l'exemple illustré, la position prédéterminée P1 de l'organe de déverrouillage 8 permettant de déterminer le premier instant t1 peut être une position d'équilibre de l'organe de déverrouillage 8.

Autrement dit, l'organe de déverrouillage 8 a une vitesse nulle lorsque l'organe de déverrouillage 8 se trouve dans la position prédéterminée P1 permettant de déterminer le premier instant t1.

Selon un mode de réalisation non représenté, la position prédéterminée P1 de l'organe de déverrouillage 8 permettant de déterminer le premier instant t1 peut être une position transitoire de l'organe de déverrouillage 8.

Dans ce cas, l'organe de déverrouillage 8 a une vitesse non nulle lorsque l'organe de déverrouillage 8 se trouve dans la position prédéterminée P1 permettant de déterminer le premier instant t1. Le premier instant t1 correspond à un passage de l'organe de déverrouillage 8 par la première position P1.

La position prédéterminée P2 de l'élément d'entrainement 9 permettant de déterminer le deuxième instant t2 peut être une position transitoire de l'élément d'entrainement 9.

Autrement dit, l'élément d'entrainement 9 a une vitesse non nulle lorsque l'élément d'entrainement 9 se trouve dans la position prédéterminée P2 permettant de déterminer le deuxième instant t2. Le deuxième instant t2 correspond à un passage de l'élément d'entrainement 9 par la deuxième position P2.

La durée D écoulée entre le premier instant t1 et le deuxième instant t2 correspond à la durée séparant le premier instant t1 et le deuxième instant t2.

La manière de déterminer le premier instant t1 dépend du type d'actionneur 1.

Lorsque l'actionneur 1 est un actionneur électromagnétique, la détermination du premier instant t1 est basée sur une mesure du courant dans l'actionneur électromagnétique 1.

On entend par mesurer un courant C circulant dans l'actionneur électromagnétique 1 le fait de mesurer l'intensité du courant électrique circulant dans l'actionneur électromagnétique 1.

Le courant C circulant dans l'actionneur électromagnétique 1 peut être détecté par un capteur 6 de mesure du courant circulant dans l'actionneur électromagnétique 1. Le courant C circulant dans l'actionneur électromagnétique 1 peut être échantillonné, par exemple avec une fréquence d'échantillonnage comprise entre 1 kHz et 100 kHz.

Dans le mode de réalisation dans lequel l'actionneur 1 est un actionneur électromagnétique, le procédé comprend les sous-étapes :

- mesurer un courant C circulant dans l'actionneur électromagnétique 1 lors de l'actionnement de l'appareil de commutation 30,

- déterminer le premier instant t1 correspondant à une position prédéterminée P1 de l'organe de déverrouillage 8 à partir des variations temporelles du courant C mesuré.

Le procédé proposé ne demande ainsi l'installation d'aucun capteur supplémentaire, tel un capteur de déplacement du contact électrique ou un capteur du déplacement d'un élément du mécanisme d'actionnement.

Le procédé proposé peut ainsi comprendre une sous-étape de détermination des variations temporelles du courant C mesuré.

L'actionneur électromagnétique 1 comprend une bobine de commande 2 et un noyau magnétique 3 configuré pour se déplacer sous l'action d'un champ magnétique créé par une circulation de courant électrique dans la bobine de commande 2.

La position prédéterminée P1 de l'organe de déverrouillage 8 correspondant au premier instant t1 est une position de déplacement maximal du noyau magnétique 3.

Autrement dit, le premier instant t1 correspond à un instant où le noyau magnétique 3 atteint sa position de déplacement maximal.

Le premier instant t1 correspondant à une position prédéterminée P1 de l'organe de déverrouillage 8 est un instant correspondant à une valeur minimale locale du courant électrique circulant dans l'actionneur électromagnétique 1.

Le premier instant t1 peut ainsi être déterminé à partir de l'évolution temporelle de l'intensité du courant circulant dans la bobine de commande 2, et coïncide avec l'instant où le courant passe par une valeur minimale locale.

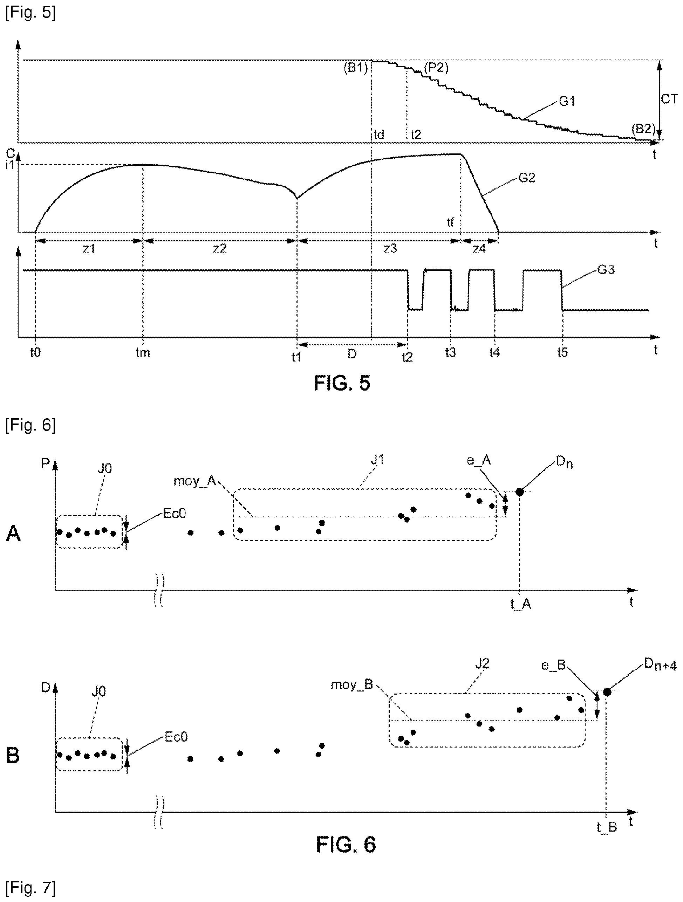

La figure 5 illustre l'évolution de plusieurs paramètres lors d'un actionnement de l'appareil de commutation. Sur la figure 5, la courbe G2 illustre l'évolution temporelle du courant électrique dans l'actionneur électromagnétique 1 lors d'une commande de celui-ci. La courbe G2 comprend une première portion z1 continument croissante, une deuxième portion z2 continument décroissante, la deuxième portion z2 suivant la première portion z1, une troisième portion z3 continument croissante, la troisième portion z3 suivant la deuxième portion z2. L'instant t1 correspondant au minimum local du courant correspond à l'instant séparant la troisième portion z3 de la deuxième portion z2.

La commande de l'électroaimant est désactivée à l'instant tf, et la portion z4 correspond à une phase de décroissance du courant jusqu'à atteindre une valeur nulle. Le courant reste nul jusqu'à la prochaine activation, ou commande, de l'électroaimant.

Une valeur maximale locale i1 du courant est obtenue pour un instant tm compris entre un instant t0 de début de circulation du courant électrique dans l'actionneur électromagnétique 1 et un instant t1 correspondant à un minimum local du courant électrique circulant dans l'actionneur électromagnétique 1.

La valeur maximale locale i1 du courant est la valeur du courant obtenue au passage de la première portion z1 à la deuxième portion z2.

La diminution du courant entre l'instant tm et l'instant t1 est liée à l'évolution de l'entrefer entre les pièces mobiles et les pièces fixes. Une fois que l'entrefer n'évolue plus, le courant recommence à augmenter, ce qui correspond à la portion z3 de la courbe G2.

A partir de l'instant t1, l'actionneur électromagnétique 1 a réalisé sa course de déplacement maximale et la position du noyau magnétique 3 n'évolue plus. La commande électrique est toutefois maintenue jusqu'à l'instant tf, afin d'assurer une force de maintien.

Lorsque l'actionneur 1 est un actionneur purement mécanique de type bouton poussoir, la détermination du premier instant t1 est basée sur le signal d'un indicateur de position, encore appelé capteur de position.

L'organe de déverrouillage 8 comprend ainsi un indicateur de position 33. L'indicateur de position 33 peut fournir un signal à deux niveaux.

L'indicateur de position 33 est un contacteur à deux états électriques.

Autrement dit, le signal de l'indicateur de position 33 bascule d'un premier niveau à un deuxième niveau lorsque l'organe de verrouillage atteint une certaine position seuil.

Ainsi, dans le mode de réalisation du procédé de détection proposé, dans lequel l'actionneur 1 comprend un bouton-poussoir 32 actionnable manuellement par un opérateur et dans lequel l'organe de déverrouillage 8 comprend un indicateur de position 33, le procédé comprend les sous-étapes :

- mesurer un signal électrique de l'indicateur de position 33,
- déterminer le premier instant t1 correspondant à une position prédéterminée P1 de l'organe de déverrouillage 8 à partir des variations temporelles du signal électrique de l'indicateur de position 33.

L'instant t1 correspond à un changement d'état électrique de l'indicateur de position 33.

L'instant t1 est une référence temporelle indiquant que l'action exercée sur le bouton poussoir par l'opérateur a bien été transmise à l'organe de déverrouillage 8.

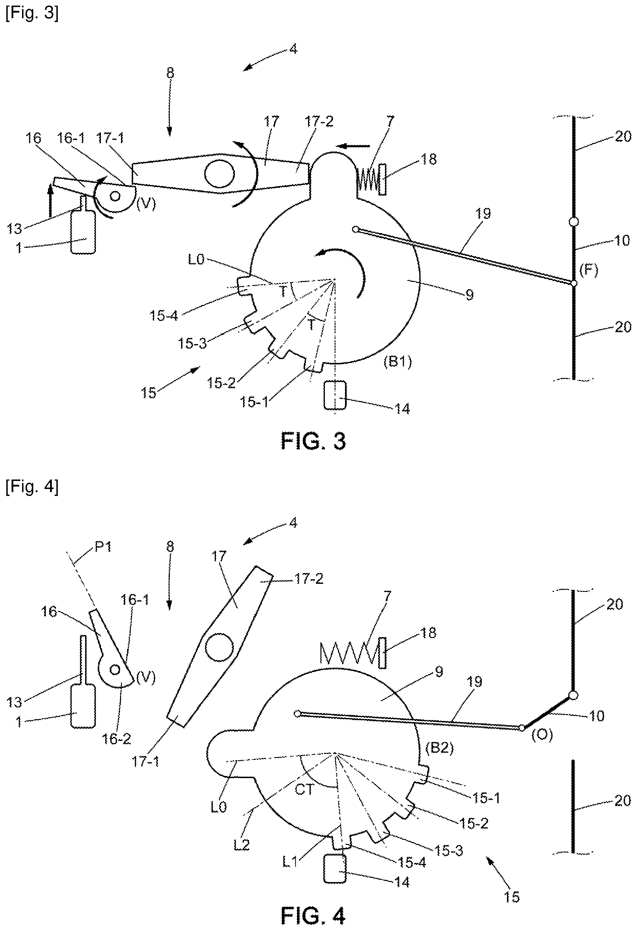

La figure 3 et la figure 4 illustrent un mode de réalisation du mécanisme de commande 4 de l'appareil de commutation 30, dans lequel l'actionneur 1 est un actionneur électromagnétique.

Afin de simplifier la figure, l'organe élastique 7 est représenté sous la forme d'un ressort hélicoïdal. L'organe élastique 7 peut aussi être un ressort spiral.

Sur la figure 3, l'organe de déverrouillage 8 est en position de verrouillage V et le ressort 7 est maintenu dans un état comprimé. Une extrémité du ressort 7 exerce un effort sur une butée fixe 18, l'autre extrémité du ressort exerce un effort sur l'élément d'entrainement 9.

L'élément d'entrainement 9 est ici mobile en rotation. L'élément d'entrainement 9 est relié au contact mobile 10 par une biellette de liaison 19.

La biellette de liaison 19 est rigide. La biellette de liaison 19 est en liaison pivot par rapport à l'élément d'entrainement 9. La biellette de liaison 19 est en liaison pivot par rapport au contact mobile 10.

L'organe de déverrouillage 8 comprend une demi-lune 16 mobile en rotation. La demi-lune 16 a une forme générale d'un demi-cylindre, et comprend une surface plane 16-1 s'étendant parallèlement à l'axe du demi-cylindre. La demi-lune 16 est actionnée par le noyau magnétique 3 de l'actionneur électromagnétique 1.

On entend par actionnée que la demi-lune 16 peut pivoter en réponse au déplacement du noyau magnétique 3. L'actionneur électromagnétique 1 comprend un élément de liaison 13 liant le noyau magnétique mobile 3 et la demi-lune 16.

L'organe de déverrouillage 8 comprend également un levier intermédiaire 17 comprenant une première portion 17-1 configurée pour coopérer avec la demi-lune 16 et comprenant une deuxième portion 17-2 configurée pour coopérer avec l'élément d'entrainement 9.

Sur la figure 3, où l'organe de déverrouillage 8 est en position de verrouillage V, la force d'entrainement de l'organe élastique 7 appliquée à l'élément d'entrainement 9 est transmise au levier intermédiaire 17 de l'organe de déverrouillage 8. La demi-lune 16 est en position de verrouillage, et bloque la rotation du levier intermédiaire 17 car la première portion 17-1 du levier intermédiaire 17 interfère avec la surface 16-1 de la demi-lune 16. La deuxième portion 17-2 bloque l'élément d'entrainement 9, qui est ainsi maintenu en place. Le ressort 7 est maintenu comprimé entre l'élément d'entrainement 9 et la butée fixe 18.

Lorsque la demi-lune 16 quitte sa position verrouillage, la première portion 17-1 n'est plus maintenue et l'effort appliqué au niveau de la deuxième portion 17-2 fait pivoter le levier intermédiaire 17. Le levier intermédiaire 17 peut ainsi pivoter sous l'action de la force d'entrainement de l'organe élastique 7. L'élément d'entrainement 9 peut ainsi se déplacer sous l'action de la force d'entrainement de l'organe élastique 7. La biellette de liaison 19, solidaire de l'élément d'entrainement 9, fait pivoter le contact mobile 10.

Sur la figure 4, l'organe de déverrouillage 8 est en position de libération L. Le ressort 7 dans l'état détendu, après avoir fait pivoter l'élément d'entrainement 9 et ainsi déplacé le contact électrique mobile 10 est position d'ouverture O. Sur la figure 4, la demi-lune 16 de l'organe de déverrouillage 8 est représentée dans la position P1 servant à définir la première référence temporelle t1.

Selon le mode de réalisation illustré, la position prédéterminée de l'élément d'entrainement 9 correspondant au deuxième instant t2 est une position intermédiaire de déplacement de l'élément d'entrainement 9. La position intermédiaire de déplacement est comprise entre une première position extrême B1 dans laquelle le contact électrique mobile 10 est en position fermée F et une deuxième position extrême B2 dans laquelle le contact électrique mobile 10 est en position ouverte O.

La figure 3 schématise la première position extrême B1 et la figure 4 schématise la deuxième position extrême B2.

Selon l'exemple illustré, une course de déplacement de l'élément d'entrainement 9 entre la première position extrême B1 et la position prédéterminée P2 correspondant au deuxième instant t2 est comprise entre 5% et 15% d'une course de déplacement totale CT de l'élément d'entrainement 9.

La partie initiale de la course de déplacement de l'élément d'entrainement 9 est ainsi utilisée pour déterminer le deuxième instant servant de référence. La sensibilité de détection du procédé proposé est ainsi améliorée.

La course de déplacement totale CT est la distance entre la première position extrême B1 et la deuxième position extrême B2 de l'élément d'entrainement 9. Dans le cas où l'élément d'entrainement 9 est mobile en rotation, la course de déplacement totale CT est une distance angulaire.

Une course angulaire CT de déplacement de l'élément d'entrainement 9 est par exemple comprise entre 40° et 60°.

Le signe L0 désigne une référence indiquant la position initiale B1 de l'élément d'entrainement 9, et le signe L1 désigne la position de cette référence après rotation complète de l'élément d'entrainement 9, lorsque celui-ci est en position B2. L'écart entre L0 et L1 indique la course de rotation CT.

Le signe L2 désigne la position de la référence L0 au moment où l'élément d'entrainement 9 est dans la position prédéterminée P2, correspondant au deuxième instant t2.

Le procédé de détection peut comprendre les sous-étapes :

- mesurer une position de l'élément d'entrainement 9 lors de l'actionnement de l'appareil de commutation 30,
- déterminer le deuxième instant t2 correspondant à la position prédéterminée P2 de l'élément d'entrainement 9 à partir de la position mesurée de l'élément d'entrainement 9.

Selon le mode de réalisation illustré ici :

- le mécanisme de commande 4 comprend un capteur de position 14 configuré pour détecter un champ magnétique,
- l'élément d'entrainement 9 comprend une pluralité d'éléments magnétiques 15 configurés pour passer successivement devant le capteur de position 14 lors d'une course de déplacement de l'élément d'entrainement 9.

Lorsque l'élément d'entrainement 9 passe de la première position extrême B1 dans laquelle le contact électrique mobile 10 est en position fermée F à une deuxième position extrême B2 dans laquelle le contact électrique mobile 10 est en position ouverte O, le passage d'un élément magnétique 15 devant le capteur de position 14 génère un changement d'état électrique du capteur de position 14. Lorsque cet élément magnétique 15 s'éloigne du capteur 14, le capteur de position 15 repasse à l'état électrique initial. La rotation de l'élément d'entrainement 9 génère donc un signal comportant une succession de créneaux, chaque créneau correspondant à un élément magnétique 15 distinct.

Les éléments magnétiques 15 peuvent être des aimants permanents.

Le capteur de position 14 peut être un capteur à effet Hall.

Les éléments magnétiques 15 sont disposés sur une partie d'une périphérie de l'élément d'entrainement 9.

Les éléments magnétiques 15 sont ici disposés dans un plan perpendiculaire à un axe de rotation de l'élément d'entrainement 9.

Les éléments magnétiques 15 sont identiques sur l'exemple illustré. Les éléments magnétiques 15 peuvent aussi être différents.

Un écart angulaire T entre deux éléments magnétiques 15 consécutifs est ici constant. Les éléments magnétiques peuvent aussi être implantés avec un écart angulaire entre deux éléments magnétiques 15 consécutifs qui n'est pas d'un élément magnétique à un autre.

L'élément d'entrainement 9 comprend sur l'exemple illustré quatre éléments magnétiques 15. Les quatre éléments magnétiques 15 sont des aimants permanents.

Sur la figure 3 et la figure 4, les 4 aimants permanents sont désignés par les signes 15-1, 15-2, 15-3, 15-4.

Un nombre différent d'éléments magnétiques peut bien sur être employé.

Sur la figure 5, la courbe G3 illustre le signal fourni par le capteur de position 14 lors du déplacement de l'élément d'entrainement 9.

L'instant t2 correspond au début du passage du premier aimant 15-1 devant le capteur de position 14.

L'instant t3 correspond au début du passage du deuxième aimant 15-2 devant le capteur de position 14.

De même, l'instant t4 correspond au début du passage du troisième aimant 15-3 et l'instant t5 correspond au début du passage du quatrième aimant 15-4.

La durée entre le passage de deux aimants consécutifs n'est pas constante car la vitesse de déplacement n'est pas constante.

Sur la figure 5, la courbe G1 indique le signal délivré par un capteur de position à haute résolution.

Autrement dit, ce capteur délivre un signal sensiblement continu et non un signal discret. Ce capteur a été monté uniquement à titre expérimental pour les besoins de validation du procédé proposé, et ne fait pas partie de l'appareil de commutation 30 lorsque celui-ci est utilisé de manière nominale. Le signal de la courbe G1 n'est pas donc exploité par le procédé proposé.

Jusqu'à l'instant td, le signal est constant, ce qui indique que l'élément d'entrainement 9 est immobile. L'élément d'entrainement 9 commence à pivoter à l'instant désigné par td.

L'instant t2 auquel le capteur de position 14 change d'état électrique en raison du passage de l'aimant 15-1 est plus tardif que l'instant td en raison de la course de déplacement nécessaire afin que l'aimant 15-1 soit dans une position située en vis-à-vis du capteur de position 14.

Comme illustré sur la figure 5, la position prédéterminée de l'élément d'entrainement 9 définissant le deuxième instant t2 correspond à la position de passage du premier aimant 15-1 devant le capteur de position 14.

La position prédéterminée P1 de l'organe de déverrouillage 8 définissant le premier instant t1 est la position de fin de pivotement de la demi-lune 16.

Le décalage temporelle entre l'instant t1 et l'instant t2 définit une durée D.

La figure 8 et la figure 9 illustrent un mode de réalisation du mécanisme de commande 4 de l'appareil de commutation 30, dans lequel l'actionneur 1 est un actionneur mécanique du type bouton poussoir.

Ce mode de réalisation diffère de celui des figures 3 et 4 par la nature de l'actionneur 1 et par la présence de l'indicateur de position 33.

Le bouton poussoir 32 est lié à la demi-lune 16 par un élément de liaison 13B. Par exemple, le bouton-poussoir 32 est solidaire d'un élément de liaison 13B lié à la demi-lune 16.

Cet élément de liaison 13B peut déplacer la demi-lune 16 de manière analogue à ce qui a été décrit dans le cadre du mode de réalisation avec actionneur électromagnétique, figures 3 et 4.

L'instant t1 est déterminé à partir du signal électrique délivré par l'indicateur de position 33. L'indicateur de position 33 comprend une languette pivotante 34 maintenue à distance d'un contacteur 35 par un ressort, non représenté. Lorsque la demi-lune 16 est distante de la languette pivotante 34, comme c'est le cas sur la figure 8, la languette est elle-même distance du contacteur 35 qui est à l'état dit relâché. L'indicateur de position 33 délivre un premier niveau de signal. Une fois que la demi-lune 16 a suffisamment pivoté, celle-ci déplace la languette pivotante 34 qui vient appuyer sur le contacteur 35 et lui faire quitter l'état relâché. L'indicateur de position 33 délivre alors un deuxième niveau de signal. L'instant correspondant à une transition entre le premier niveau de signal et le deuxième niveau de signal permet de déterminer le premier instant t1.

Dans ce mode de réalisation, le reste du mécanisme de commande 4 est identique au mode de réalisation des figures 3 et 4, et la détermination du deuxième instant t2 est réalisée de la même manière.

La durée déterminée D est le paramètre physique sur lequel le procédé de détection d'une dégradation du mécanisme de commande 4 est basé.

Un traitement statistique est appliqué à ce paramètre physique.

Le procédé de détection comprend ainsi la sous-étape :

- calculer une valeur d'un paramètre statistique P représentatif d'une fluctuation des valeurs de l'ensemble E de valeurs de la durée D écoulée entre le premier instant t1 et le deuxième instant t2,
- déterminer une dégradation de l'organe de déverrouillage 8 à partir de la valeur calculée du paramètre statistique P.

Selon un exemple de mise en œuvre du procédé de détection, le paramètre statistique P représentatif d'une fluctuation des valeurs de l'ensemble E de valeurs de la durée D écoulée entre le premier instant t1 et le deuxième instant t2 comprend une différence entre :

- une valeur courante de la durée D écoulée entre le premier instant t1 et le deuxième instant t2, déterminée pour un actionnement courant de l'appareil de commutation 30, et
- une valeur moyenne Moy des valeurs de la durée D écoulée entre le premier instant t1 et le deuxième instant t2 obtenues pour un nombre prédéterminé M d'actionnements précédant l'actionnement courant de l'appareil de commutation 30.

La valeur moyenne Moy peut être une moyenne glissante calculée à partir des valeurs correspondant aux actionnements précédent l'actionnement courant, et comprenant un nombre de valeurs égal au nombre prédéterminé M d'actionnements.

Selon un exemple de mise en œuvre du procédé de détection, le paramètre statistique P représentatif d'une fluctuation des valeurs de l'ensemble E de valeurs de la durée D écoulée entre le premier instant t1 et le deuxième instant t2 comprend un écart-type des valeurs de la durée D écoulée entre le premier instant t1 et le deuxième instant t2 déterminé pour un ensemble d'actionnements de l'appareil de commutation 30 réalisés dans des conditions de référence correspondant à un état neuf du disjoncteur 30.

L'ensemble d'actionnements de l'appareil de commutation 30 réalisés dans des conditions de référence comprend par exemple 20 actionnements successifs de l'appareil de commutation 30.

Le procédé proposé comprend ainsi une phase de calibration permettant de quantifier les variations nominales de la valeur de la durée D écoulée entre le premier instant t1 et le deuxième instant t2 lors de l'actionnement de l'appareil de commutation 30. Ces variations nominales correspondent aux variations observées dans un état de référence dans lequel l'appareil de commutation 30 ne présente ni défaut de montage ni dégradation due à l'usure.

L'état de référence correspond par exemple à un état neuf de l'appareil de commutation 30.

Le procédé proposé comprend une phase de mesure dans laquelle les variations de la valeur de la durée D écoulée entre le premier instant t1 et le deuxième instant t2 sont analysées.

La phase de mesure suit la phase de calibration.

La phase de mesure est réalisée tout au long de la durée d'utilisation de l'appareil de commutation 30.

Les valeurs acquises dans ces conditions de référence permettent de déterminer la variabilité nominale de la durée D écoulée entre le premier instant t1 et le deuxième instant t2. Cette variabilité nominale est ici caractérisée par la grandeur mathématique égale à l'écart-type de la durée D écoulée entre le premier instant t1 et le deuxième instant t2, calculé pour l'ensemble des mesures réalisées dans les conditions de référence. Cette variabilité nominale est caractérisée à partir d'un nombre prédéterminé de valeurs correspondant à un nombre prédéterminé d'actionnements.

Par exemple, 20 actionnements successifs réalisés à l'état neuf de l'appareil de commutation 30 peuvent permettre de caractériser la variabilité nominale de la quantité utilisée pour déterminer une dégradation de l'appareil de commutation 30.

La figure 6 illustre les valeurs de la durée D entre le premier instant t1 et le deuxième instant t2, pour différents actionnements de l'appareil de commutation 30. La partie A schématise les mesures réalisées à un premier instant t_A. La partie B de la figure schématise les mesures réalisées à un deuxième instant t_B, qui est postérieur à t_A.

Les points de mesure encadrés par le cadre désigné par J0 sont ceux réalisés dans des conditions de référence correspondant à un état neuf de l'appareil de commutation 30. Pour simplifier la figure, seuls 7 points de mesure ont été représentés. On peut remarquer que la dispersion des valeurs de la quantité D est faible.

Le signe Ec0 désigne l'écart-type des valeurs correspondant à l'ensemble d'actionnements de l'appareil de commutation 30 réalisés dans des conditions de référence, et prises en compte pour la phase de calibration.

Sur la partie A de la figure 6, les points de mesure encadrés par le cadre désigné par J1 sont les points utilisés à l'instant t_A pour la phase de mesure. Comme précédemment, pour simplifier la figure seuls 10 points de mesure de la durée D ont été représentés.

La valeur $D_n$, déterminée au temps t_A, est la valeur courant à l'instant t_A, c'est-à-dire la valeur la plus récente.

Le trait horizontal en pointillés indique la valeur moyenne moy_A des valeurs prises en compte, c'est-à-dire celles présentes dans le cadre J1.

La flèche désignée par e_A illustre l'écart entre la valeur courante $D_n$ et la valeur moyenne moy_A calculée sur cet exemple à partir des 10 points de mesure précédant la mesure courante $D_n$.

Sur la partie B de la figure 6, les points de mesure encadrés par le cadre désigné par J2 sont les points utilisés à l'instant t_B pour la phase de mesure. Comme précédemment, 10 points de mesure sont utilisés sur la figure.

La valeur déterminée au temps t_B, est la valeur courante à l'instant t_B, c'est-à-dire la valeur la plus récente. Par rapport à l'instant t_A, 4 nouvelles mesures ont été acquises, et les 4 valeurs les plus anciennes du cadre J1 ne sont pas utilisées à l'instant t_B et ne font pas partie du cadre J2.

Le trait horizontal en pointillés indique la valeur moyenne moy_B des valeurs prises en compte, c'est-à-dire celles présentes dans le cadre J2.

La flèche désignée par e_B illustre l'écart entre la valeur courante $D_{n+4}$ et la valeur moyenne moy_B.

Plus précisément, le paramètre statistique P représentatif d'une fluctuation de la durée D écoulée entre le premier instant t1 et le deuxième instant t2 est égal au rapport de :

- la différence entre une valeur courante Di de la durée D écoulée entre le premier instant t1 et le deuxième instant t2 et la valeur moyenne Moy des valeurs de la durée D écoulée entre le premier instant t1 et le deuxième instant t2 obtenues pour un nombre prédéterminé M d'actionnements précédant l'actionnement courant, et de
- l'écart-type Ec des valeurs de la durée D écoulée entre le premier instant t1 et le deuxième instant t2 déterminé pour un ensemble d'actionnements de l'appareil de commutation 30 réalisés dans des conditions de référence correspondant à un état neuf de l'appareil de commutation 30.

Le paramètre statistique P proposé permet une détection robuste d'une éventuelle dégradation de l'organe de déverrouillage 8 du mécanisme de commande 4 de l'appareil de commutation 30, tout en étant simple à mettre en œuvre. En particulier, les calculs nécessaires sont facilement réalisables en temps réel, ce qui permet une détection rapide d'une dégradation.

Le paramètre statistique P représentatif d'une fluctuation de la durée D écoulée entre le premier instant t1 et le deuxième instant t2 est ainsi égal à :

[Math. 1]

$$P(i) = \frac{D_i - \frac{\sum_{j=i-M}^{j=i-1} D_j}{M}}{\sqrt{\sum_{j=1}^{N}\left(\frac{D_j - \frac{\sum_{j=1}^{j=N} D_j}{K}}{K}\right)^2}}$$

Avec $D_i$ la valeur déterminée de la durée D pour un actionnement de rang i,

P(i) la valeur calculée du paramètre statistique P pour l'actionnement de rang i,
M le nombre d'actionnements pris en compte pour déterminer une valeur moyenne,
K le nombre d'actionnements réalisés dans des conditions de référence correspondant à un état neuf de l'appareil de commutation 30.

Le calcul réalisé du paramètre statistique P permet de conclure sur l'état du mécanisme de commande 4.

Une dégradation de l'organe de déverrouillage 8 est déterminée lorsque la valeur absolue du paramètre statistique P représentatif d'une fluctuation de la durée D écoulée entre le premier instant t1 et le deuxième instant t2 est supérieure à un premier seuil prédéterminé positif S1.

La valeur choisie pour le premier seuil prédéterminé S1 permet d'ajuster la sensibilité du procédé de détection proposé.

Le premier seuil prédéterminé S1 est par exemple compris entre 2 et 3.

Selon un exemple de réalisation du procédé de détection, la dégradation de l'organe de déverrouillage 8 est classifiée en un premier type de dégradation, dit dégradation mineure, lorsque la valeur absolue du paramètre statistique P représentatif d'une fluctuation de la durée D écoulée entre le premier instant t1 et le deuxième instant t2 est supérieure à un premier seuil prédéterminé positif S1 et inférieure à un deuxième seuil prédéterminé positif S2.

Le deuxième seuil prédéterminé positif S2 est par exemple compris entre 4 et 5.

La dégradation de l'organe de déverrouillage 8 est classifiée en un deuxième type de dégradation, dit dégradation majeure, lorsque la valeur absolue du paramètre D représentatif d'une fluctuation de la durée D écoulée entre le premier instant t1 et le deuxième instant t2 est supérieur au deuxième seuil prédéterminé S2.

Le paramètre statistique P utilisé permet ainsi une quantification de la dégradation, et non uniquement une détermination de présence ou d'absence de dégradation.

Le procédé de détection peut comprendre une étape d'émission d'un signal d'alerte en réponse à une détermination d'une dégradation de l'organe de déverrouillage 8.

Le signal d'alerte émis permet aux utilisateurs de planifier et de réaliser une opération de maintenance ou de remplacement de l'appareil de commutation 30.

Le signal d'alerte peut être par exemple un code mémorisé dans une unité électronique de contrôle.

En variante ou de manière complémentaire, le signal d'alerte peut être un allumage d'un voyant.

En variante encore ou en complément, le signal d'alerte peut être un affichage d'un message sur un écran de contrôle.

D'autres types d'alerte sont bien sur possibles.

Aucun signal d'alerte n'est émis lorsqu'aucune dégradation n'a été déterminée. Autrement dit, aucune alerte n'est émise lorsque le procédé proposé indique que le mécanisme de commande 4 est exempt de dégradation.

## Revendications

1. Procédé de détection d'une dégradation d'un appareil de commutation (30) comprenant :

   - un contact électrique (10) mobile entre une position de fermeture (F) d'un circuit électrique (50) et une position d'ouverture (O) du circuit électrique (50),
   - un mécanisme de commande (4) comprenant :

      -- un élément d'entrainement (9) configuré pour déplacer le contact électrique mobile (10) de façon à ouvrir un circuit électrique (50),
      -- un organe élastique (7) lié à l'élément d'entrainement (9),
      -- un organe de déverrouillage (8) configuré pour passer d'une position de verrouillage (V) dans laquelle l'organe élastique (7) est maintenu dans un état de tension à une position de libération (L) dans laquelle l'organe élastique (7) est libre de se détendre de façon à déplacer le contact électrique (10) de la position de fermeture (F) à la position d'ouverture (O) du circuit électrique (50), ou de la position d'ouverture (O) à la position de fermeture (F),

   - un actionneur (1) configuré pour déplacer l'organe de déverrouillage (8) de la position de verrouillage (V) à la position de libération (L),

   le procédé comportant les étapes :

      (i) commander l'actionneur (1) de façon à déplacer l'organe de déverrouillage (8) de la position de verrouillage (V) à la position de libération (L),

   **caractérisé en ce que** le procédé comporte en outre les étapes :

      (ii) déterminer un premier instant (t1) correspondant à une position prédéterminée (P1) de l'organe de déverrouillage (8),
      (iii) déterminer un deuxième instant (t2) correspondant à une position prédéterminée (P2) de l'élément d'entrainement (9),

(iv) déterminer une durée (D) écoulée entre le premier instant (t1) et le deuxième instant (t2),

(v) itérer les étapes (i) à (iii) pour un ensemble de commandes successives de l'actionneur (1), de façon à obtenir un ensemble (E) de valeurs de la durée (D) écoulée entre le premier instant (t1) et le deuxième instant (t2),

(vi) déterminer une dégradation de l'organe de déverrouillage (8) de l'appareil de commutation (30) à partir de l'évolution des valeurs de l'ensemble (E) au cours des commandes successives de l'actionneur (1).

2. Procédé de détection selon la revendication 1, dans lequel l'actionneur (1) est un actionneur électromagnétique, et dans lequel le procédé comprend les sous-étapes :

- mesurer un courant (C) circulant dans l'actionneur électromagnétique (1) lors de l'actionnement de l'appareil de commutation (30),
- déterminer le premier instant (t1) correspondant à une position prédéterminée (P1) de l'organe de déverrouillage (8) à partir des variations temporelles du courant (C) mesuré.

3. Procédé de détection selon la revendication 2,

dans lequel l'actionneur électromagnétique (1) comprend une bobine de commande (2) et un noyau magnétique (3) configuré pour se déplacer sous l'action d'un champ magnétique créé par une circulation de courant électrique dans la bobine de commande (2),

et dans lequel la position prédéterminée (P1) de l'organe de déverrouillage (8) correspondant au premier instant (t1) est une position de déplacement maximal du noyau magnétique (3).

4. Procédé de détection selon la revendication 2 ou 3, dans lequel le premier instant (t1) correspondant à une position prédéterminée (P1) de l'organe de déverrouillage (8) est un instant (tm) correspondant à une valeur minimale locale du courant électrique circulant dans l'actionneur électromagnétique (1).

5. Procédé de détection selon la revendication 1, dans lequel l'actionneur (1) comprend un bouton-poussoir (32) actionnable manuellement par un opérateur et dans lequel l'organe de déverrouillage (8) comprend un indicateur de position (33), dans lequel le procédé comprend les sous-étapes :

- mesurer un signal électrique de l'indicateur de position (33),
- déterminer le premier instant (t1) correspondant à une position prédéterminée (P1) de l'organe de déverrouillage (8) à partir des variations temporelles du signal électrique de l'indicateur de position (33).

6. Procédé de détection selon l'une des revendications précédentes, dans lequel la position prédéterminée de l'élément d'entrainement (9) correspondant au deuxième instant (t2) est une position intermédiaire de déplacement de l'élément d'entrainement (9), la position intermédiaire de déplacement étant comprise entre une première position extrême (B1) dans laquelle le contact électrique mobile (10) est en position fermée (F) et une deuxième position extrême (B2) dans laquelle le contact électrique mobile (10) est en position ouverte (O).

7. Procédé de détection selon la revendication précédente, dans lequel une course de déplacement de l'élément d'entrainement (9) entre la première position extrême (B1) et la position prédéterminée (P2) correspondant au deuxième instant (t2) est comprise entre 5% et 15% d'une course de déplacement totale (CT) de l'élément d'entrainement (9).

8. Procédé de détection selon l'une des revendications précédentes, comprenant les sous-étapes :

- mesurer une position de l'élément d'entrainement (9) lors de l'actionnement de l'appareil de commutation (30),
- déterminer le deuxième instant (t2) correspondant à la position prédéterminée (P2) de l'élément d'entrainement (9) à partir de la position mesurée de l'élément d'entrainement (9).

9. Procédé de détection selon l'une des revendications précédentes, dans lequel :

- le mécanisme de commande (4) comprend un capteur de position (14) configuré pour détecter un champ magnétique,
- l'élément d'entrainement (9) comprend une pluralité d'éléments magnétiques (15) configurés pour passer successivement devant le capteur de position (14) lors d'une course de déplacement de l'élément d'entrainement (9).

10. Procédé de détection selon l'une des revendications précédentes, comprenant la sous-étape :

- calculer une valeur d'un paramètre statistique (P) représentatif d'une fluctuation des valeurs de l'ensemble (E) de valeurs de la durée (D) écoulée entre le premier instant (t1) et le deuxième instant (t2),
- déterminer une dégradation de l'organe de déverrouillage (8) à partir de la valeur calculée du paramètre statistique (P).

11. Procédé de détection selon la revendication précédente, dans lequel le paramètre statistique (P) représentatif d'une fluctuation des valeurs de l'ensemble (E) de valeurs de la durée (D) écoulée entre le premier instant (t1) et le deuxième instant (t2) comprend une différence (X) entre :

- une valeur courante de la durée (D) écoulée entre le premier instant (t1) et le deuxième instant (t2), déterminée pour un actionnement courant de l'appareil de commutation (30), et
- une valeur moyenne (Moy) des valeurs de la durée (D) écoulée entre le premier instant (t1) et le deuxième instant (t2) obtenues pour un nombre prédéterminé (M) d'actionnements précédant l'actionnement courant de l'appareil de commutation (30).

12. Procédé de détection selon la revendication 10 ou 11, dans lequel le paramètre statistique (P) représentatif d'une fluctuation des valeurs de l'ensemble (E) de valeurs de la durée (D) écoulée entre le premier instant (t1) et le deuxième instant (t2) comprend un écart-type des valeurs de la durée (D) écoulée entre le premier instant (t1) et le deuxième instant (t2) déterminé pour un ensemble d'actionnements de l'appareil de commutation (30) réalisés dans des conditions de référence correspondant à un état neuf du disjoncteur (30).

13. Procédé de détection selon l'une des revendications 10 à 12, dans lequel le paramètre statistique (P) représentatif d'une fluctuation de la durée (D) écoulée entre le premier instant (t1) et le deuxième instant (t2) est égal au rapport de :

- la différence (X) entre une valeur courante (Di) de la durée (D) écoulée entre le premier instant (t1) et le deuxième instant (t2) et la valeur moyenne (Moy) des valeurs de la durée (D) écoulée entre le premier instant (t1) et le deuxième instant (t2) obtenues pour un nombre prédéterminé (M) d'actionnements précédant l'actionnement courant, et de
- l'écart-type (Ec) des valeurs de la durée (D) écoulée entre le premier instant (t1) et le deuxième instant (t2) déterminé pour un ensemble d'actionnements de l'appareil de commutation (30) réalisés dans des conditions de référence correspondant à un état neuf de l'appareil de commutation (30).

14. Procédé de détection selon l'une des revendications 10 à 13, dans lequel le paramètre statistique (P) représentatif d'une fluctuation de la durée (D) écoulée entre le premier instant (t1) et le deuxième instant (t2) est égal à :

[Math. 1]

$$P(i) = \frac{D_i - \frac{\sum_{j=i-M}^{j=i-1} D_j}{M}}{\sqrt{\sum_{j=1}^{N} \left( \frac{D_j - \frac{\sum_{j=1}^{j=N} D_j}{K}}{K} \right)^2}}$$

Avec $D_i$ la valeur déterminée de la durée D pour un actionnement de rang i,

P(i) la valeur calculée du paramètre statistique P pour l'actionnement de rang i,
M le nombre d'actionnements pris en compte pour déterminer une valeur moyenne,
K le nombre d'actionnements réalisés dans des conditions de référence correspondant à un état neuf de l'appareil de commutation 30.

**15.** Procédé de détection selon l'une des revendications 10 à 14, dans lequel une dégradation de l'organe de déverrouillage (8) est déterminée lorsque la valeur absolue du paramètre statistique (P) représentatif d'une fluctuation de la durée (D) écoulée entre le premier instant (t1) et le deuxième instant (t2) est supérieure à un premier seuil prédéterminé positif (S1).

**16.** Procédé de détection selon la revendication précédente, dans lequel :

- la dégradation de l'organe de déverrouillage (8) est classifiée en un premier type de dégradation, dit dégradation mineure, lorsque la valeur absolue du paramètre statistique (P) représentatif d'une fluctuation de la durée (D) écoulée entre le premier instant (t1) et le deuxième instant (t2) est supérieure à un premier seuil prédéterminé positif (S1) et inférieure à un deuxième seuil prédéterminé positif (S2), et dans lequel :
- la dégradation de de l'organe de déverrouillage (8) est classifiée en un deuxième type de dégradation, dit dégradation majeure, lorsque la valeur absolue du paramètre statistique (P) représentatif d'une fluctuation de la durée (D) écoulée entre le premier instant (t1) et le deuxième instant (t2) est supérieure au deuxième seuil prédéterminé positif (S2).

**17.** Procédé de détection selon la revendication 15 ou 16, comprenant une étape d'émission d'un signal d'alerte en réponse à une détermination d'une dégradation de l'organe de déverrouillage (8).

**18.** Appareil de commutation (30) comprenant :

- un contact électrique (10) mobile entre une position de fermeture (F) d'un circuit électrique (50) et une position d'ouverture (O) du circuit électrique (50),
- un mécanisme de commande (4) comprenant :

-- un élément d'entrainement (9) configuré pour déplacer le contact électrique mobile (10) de façon à ouvrir un circuit électrique (50),
-- un organe élastique (7) lié à l'élément d'entrainement (9),
-- un organe de déverrouillage (8) configuré pour passer d'une position de verrouillage (V) dans laquelle l'organe élastique (7) est maintenu dans un état de tension à une position de libération (L) dans laquelle l'organe élastique (7) est libre de se détendre de façon à déplacer le contact électrique (10) de la position de fermeture (F) à la position d'ouverture (O) du circuit électrique (50),

- un actionneur (1) configuré pour déplacer l'organe de déverrouillage (8) de la position de verrouillage (V) à la position de libération (L),
- une unité électronique de contrôle (25) configurée pour mettre en œuvre le procédé de détection de dégradation selon l'une des revendications précédentes, l'appareil de commutation (30) étant un disjoncteur, ou un interrupteur, ou un sectionneur.

**Patentansprüche**

**1.** Erkennungsverfahren einer Beschädigung einer Schaltvorrichtung (30), umfassend:

- einen elektrischen Kontakt (10), der zwischen einer Schließposition (F) eines elektrischen Stromkreises (50) und einer Öffnungsposition (O) des elektrischen Stromkreises (50) beweglich ist,
- einen Steuermechanismus (4), umfassend:

-- ein Antriebselement (9), das so eingerichtet ist, dass es den beweglichen elektrischen Kontakt (10) so bewegt, dass er einen elektrischen Stromkreis (50) öffnet,
-- ein elastisches Element (7), das mit dem Antriebselement (9) verbunden ist,
- ein Entriegelungselement (8), das so eingerichtet ist, dass es aus einer Verriegelungsposition (V), in der das elastische Element (7) in einem Spannungszustand gehalten wird, in eine Freigabeposition (L) wechselt, in der das elastische Element (7) frei ist, sich zu entspannen, so dass der elektrische Kontakt (10) von der Schließposition (F) in die Öffnungsposition (O) des elektrischen Stromkreises (50) oder von der Öffnungsposition (O) in die Schließposition (F) bewegt wird,

- ein Stellglied (1), das so eingerichtet ist, dass es das Entriegelungselement (8) aus der Verriegelungsposition (V) in die Freigabeposition (L) bewegt,

wobei das Verfahren folgende Schritte aufweist:

(i) Steuern des Stellglieds (1), so dass das Entriegelungselement (8) aus der Verriegelungsposition (V) in die Freigabeposition (L) bewegt wird,

**dadurch gekennzeichnet, dass** das Verfahren ferner folgende Schritte aufweist:

(ii) Bestimmen eines ersten Zeitpunkts (t1), der einer vorbestimmten Position (P1) des Entriegelungselements (8) entspricht,
(iii) Bestimmen eines zweiten Zeitpunkts (t2), der einer vorbestimmten Position (P2) des Antriebselements (9) entspricht,
(iv) Bestimmen einer Dauer (D), die zwischen dem ersten Zeitpunkt (t1) und dem zweiten Zeitpunkt (t2) verstrichen ist,
(v) Wiederholen der Schritte (i) bis (iii) für eine Reihe von aufeinanderfolgenden Steuerungen des Stellglieds (1), um eine Reihe (E) von Werten der zwischen dem ersten Zeitpunkt (t1) und dem zweiten Zeitpunkt (t2) vergangenen Dauer (D) zu erhalten,
(vi) Bestimmen einer Beschädigung des Entriegelungselements (8) der Schaltvorrichtung (30) anhand der Entwicklung der Werte der Baugruppe (E) während der aufeinanderfolgenden Steuerungen des Stellglieds (1).

2. Erkennungsverfahren nach Anspruch 1, wobei das Stellglied (1) ein elektromagnetisches Stellglied ist, und wobei das Verfahren folgende Unterschritte umfasst:

- Messen eines Stroms (C), der bei dem Betätigen der Schaltvorrichtung (30) in dem elektromagnetischen Stellglied (1) fließt,
- Bestimmen des ersten Zeitpunkts (t1), der einer vorbestimmten Position (P1) des Entriegelungselements (8) entspricht, aus den zeitlichen Schwankungen des gemessenen Stroms (C).

3. Erkennungsverfahren nach Anspruch 2,

wobei das elektromagnetische Stellglied (1) eine Steuerspule (2) und einen Magnetkern (3) umfasst, der so eingerichtet ist, dass er sich unter Einwirkung eines Magnetfelds bewegt, das durch einen elektrischen Stromfluss in der Steuerspule (2) erzeugt wird,
und wobei die dem ersten Zeitpunkt (t1) entsprechende vorbestimmte Position (P1) des Entriegelungselements (8) eine maximale Verschiebeposition des Magnetkerns (3) ist.

4. Erkennungsverfahren nach Anspruch 2 oder 3, wobei der erste Zeitpunkt (t1), der einer vorbestimmten Position (P1) des Entriegelungselements (8) entspricht, ein Zeitpunkt (tm) ist, der einem lokalen Mindestwert des in dem elektromagnetischen Stellglied (1) fließenden elektrischen Stroms entspricht.

5. Erkennungsverfahren nach Anspruch 1, wobei das Stellglied (1) einen von einem Bediener manuell betätigbaren Drucktaster (32) umfasst und wobei das Entriegelungselement (8) einen Positionsanzeiger (33) umfasst, wobei das Verfahren folgende Unterschritte umfasst:

- Messen eines elektrischen Signals des Positionsanzeigers (33),
- Bestimmen des ersten Zeitpunkts (t1), der einer vorbestimmten Position (P1) des Entriegelungselements (8) entspricht, aus den zeitlichen Schwankungen des elektrischen Signals des Positionsanzeigers (33).

6. Erkennungsverfahren nach einem der vorhergehenden Ansprüche, wobei die dem zweiten Zeitpunkt (t2) entsprechende vorbestimmte Position des Antriebselements (9) eine Zwischenposition zur Verschiebung des Antriebselements (9) ist, wobei die Zwischenposition zur Verschiebung zwischen einer ersten Endposition (B1), in der der bewegliche elektrische Kontakt (10) in der geschlossenen Position (F) ist, und einer zweiten Endposition (B2), in der der bewegliche elektrische Kontakt (10) in geöffneter Position (O) ist, liegt.

7. Erkennungsverfahren nach dem vorhergehenden Anspruch, wobei ein Verfahrweg des Antriebselements (9) zwischen der ersten Endposition (B1) und der dem zweiten Zeitpunkt (t2) entsprechenden vorbestimmten Position (P2) zwischen 5 % und 15 % eines Gesamtverfahrwegs (CT) des Antriebselements (9) liegt.

8. Erkennungsverfahren nach einem der vorhergehenden Ansprüche, umfassend folgende Unterschritte:

- Messen einer Position des Antriebselements (9) bei dem Betätigen der Schaltvorrichtung (30),
- Bestimmen des zweiten Zeitpunkts (t2), der der vorbestimmten Position (P2) des Antriebselements (9) ausgehend von der gemessenen Position des Antriebselements (9) entspricht.

9. Erkennungsverfahren nach einem der vorhergehenden Ansprüche, wobei:

- der Steuermechanismus (4) einen Positionssensor (14) umfasst, der so eingerichtet ist, dass er ein Magnetfeld erkennt,
- das Antriebselement (9) eine Vielzahl von Magnetelementen (15) umfasst, die so eingerichtet sind, dass sie bei einem Verfahrweg des Antriebselements (9) nacheinander vorbei an dem Positionssensor (14) fahren.

10. Erkennungsverfahren nach einem der vorhergehenden Ansprüche, umfassend folgenden Unterschritt:

- Berechnen eines Wertes eines statistischen Parameters (P), der für eine Schwankung der Werte des Wertesatzes (E) der zwischen dem ersten Zeitpunkt (t1) und dem zweiten Zeitpunkt (t2) vergangenen Dauer (D) repräsentativ ist,
- Bestimmen einer Beschädigung des Entriegelungselements (8) aus dem berechneten Wert des statistischen Parameters (P).

11. Erkennungsverfahren nach dem vorhergehenden Anspruch, wobei der statistische Parameter (P), der für eine Schwankung der Werte des Wertesatzes (E) der zwischen dem ersten Zeitpunkt (t1) und dem zweiten Zeitpunkt (t2) vergangenen Dauer (D) repräsentativ ist, eine Differenz (X) zwischen Folgendem umfasst:

- einem aktuellen Wert der Dauer (D), die zwischen dem ersten Zeitpunkt (t1) und dem zweiten Zeitpunkt (t2) vergangen ist, der für eine aktuelle Betätigung der Schaltvorrichtung (30) bestimmt ist, und
- einem Mittelwert (Moy) der Werte der zwischen dem ersten Zeitpunkt (t1) und dem zweiten Zeitpunkt (t2) verstrichenen Zeit (D), die für eine vorbestimmte Anzahl (M) von Betätigungen vor der aktuellen Betätigung der Schaltvorrichtung (30) erhalten wurden.

12. Erkennungsverfahren nach Anspruch 10 oder 11, wobei der statistische Parameter (P), der für eine Schwankung der Werte des Wertesatzes (E) der zwischen dem ersten Zeitpunkt (t1) und dem zweiten Zeitpunkt (t2) vergangenen Dauer (D) repräsentativ ist, eine Standardabweichung der Werte der zwischen dem ersten Zeitpunkt (t1) und dem zweiten Zeitpunkt (t2) vergangenen Dauer (D) umfasst, die für einen Satz von Betätigungen der Schaltvorrichtung (30) bestimmt wurde, die unter Referenzbedingungen durchgeführt wurden, die einem Neuzustand des Leistungsschalters (30) entsprechen.

13. Erkennungsverfahren nach einem der Ansprüche 10 bis 12, wobei der statistische Parameter (P), der für eine Schwankung der zwischen dem ersten Zeitpunkt (t1) und dem zweiten Zeitpunkt (t2) vergangenen Dauer (D) repräsentativ ist, gleich folgendem Verhältnis ist:

- der Differenz (X) zwischen einem aktuellen Wert (Di) der zwischen dem ersten Zeitpunkt (t1) und dem zweiten Zeitpunkt (t2) vergangenen Dauer (D) und dem Mittelwert (Moy) der Werte der zwischen dem ersten Zeitpunkt (t1) und dem zweiten Zeitpunkt (t2) vergangenen Dauer (D), die für eine vorbestimmte Anzahl (M) von Betätigungen vor der aktuellen Betätigung erhalten wurden, und
- der Standardabweichung (Ec) der Werte der zwischen dem ersten Zeitpunkt (t1) und dem zweiten Zeitpunkt (t2) ermittelten Zeit (D) für eine Reihe von Betätigungen der Schaltvorrichtung (30), die unter Referenzbedingungen durchgeführt werden, die einem Neuzustand der Schaltvorrichtung (30) entsprechen.

14. Erkennungsverfahren nach einem der Ansprüche 10 bis 13, wobei der statistische Parameter (P), der für eine Schwankung der zwischen dem ersten Zeitpunkt (t1) und dem zweiten Zeitpunkt (t2) vergangenen Dauer (D) repräsentativ ist, gleich Folgendem ist:

[Math. 1]

$$P(i) = \frac{D_i - \frac{\sum_{j=i-\mathrm{M}}^{j=i-1} D_j}{\mathrm{M}}}{\sqrt{\sum_{j=1}^{N}\left(\frac{D_j - \frac{\sum_{j=1}^{j=N} D_j}{K}}{K}\right)^2}}$$

Mit $D_i$ der ermittelte Wert der Dauer D für eine Ansteuerung der Reihe i,

P(i) der berechnete Wert des statistischen Parameters P für die Ansteuerung von Reihe i,
M die Anzahl der Betätigungen, die zur Ermittlung eines Mittelwerts berücksichtigt werden,
K die Anzahl der Betätigungen, die unter Referenzbedingungen durchgeführt wurden, die einem Neuzustand der Schaltvorrichtung 30 entsprechen.

15. Erkennungsverfahren nach einem der Ansprüche 10 bis 14, wobei eine Beschädigung des Entriegelungselements (8) bestimmt wird, wenn der absolute Wert des statistischen Parameters (P), der für eine Schwankung der zwischen dem ersten Zeitpunkt (t1) und dem zweiten Zeitpunkt (t2) vergangenen Dauer (D) repräsentativ ist, größer ist als ein erster vorbestimmter positiver Schwellenwert (S1).

16. Erkennungsverfahren nach dem vorhergehenden Anspruch, wobei:

- die Beschädigung des Entriegelungselements (8) in eine erste Art von Beschädigung, die als geringfügige Beschädigung bezeichnet wird, eingestuft wird, wenn der absolute Wert des statistischen Parameters (P), der für eine Schwankung der zwischen dem ersten Zeitpunkt (t1) und dem zweiten Zeitpunkt (t2) vergangenen Dauer (D) repräsentativ ist, größer ist als ein erster vorbestimmter positiver Schwellenwert (S1) und kleiner ist als ein zweiter vorbestimmter positiver Schwellenwert (S2), und wobei:
- die Beschädigung des Entriegelungselements (8) in eine zweite Art von Beschädigung, die als schwerwiegende Beschädigung bezeichnet wird, eingestuft wird, wenn der absolute Wert des statistischen Parameters (P), der für eine Schwankung der zwischen dem ersten Zeitpunkt (t1) und dem zweiten Zeitpunkt (t2) vergangenen Dauer (D) repräsentativ ist, größer ist als der zweite vorbestimmte positive Schwellenwert (S2).

17. Erkennungsverfahren nach Anspruch 15 oder 16, umfassend einen Schritt der Ausgabe eines Warnsignals als Reaktion auf eine Bestimmung einer Beschädigung des Entriegelungselements (8).

18. Schaltvorrichtung (30), umfassend:

- einen elektrischen Kontakt (10), der zwischen einer Schließposition (F) eines elektrischen Stromkreises (50) und einer Öffnungsposition (O) des elektrischen Stromkreises (50) beweglich ist,
- einen Steuermechanismus (4), umfassend:
- ein Antriebselement (9), das so eingerichtet ist, dass es den beweglichen elektrischen Kontakt (10) so bewegt, dass er einen elektrischen Stromkreis (50) öffnet,

-- ein elastisches Element (7), das mit dem Antriebselement (9) verbunden ist,

- ein Entriegelungselement (8), das so eingerichtet ist, dass es aus einer Verriegelungsposition (V), in der das elastische Element (7) in einem Spannungszustand gehalten wird, in eine Freigabeposition (L) wechselt, in der das elastische Element (7) frei ist, sich zu entspannen, so dass der elektrische Kontakt (10) von der Schließposition (F) in die Öffnungsposition (O) des elektrischen Stromkreises (50) bewegt wird,
- ein Stellglied (1), das so eingerichtet ist, dass es das Entriegelungselement (8) aus der Verriegelungsposition (V) in die Freigabeposition (L) bewegt,
- eine elektronische Steuereinheit (25), die so eingerichtet ist, dass sie das Verfahren zur Erkennung von Beschädigungen nach einem der vorhergehenden Ansprüche umsetzt, wobei die Schaltvorrichtung (30) ein Leistungsschalter, ein Schalter oder ein Trennschalter ist.

**Claims**

1. A method for detecting a degradation of a switching device (30) comprising:

   - an electrical contact (10) movable between a closing position (F) of an electrical circuit (50) and an opening position (O) of the electrical circuit (50),
   - a control mechanism (4) comprising:

     -- a driving element (9) configured to move the movable electrical contact (10) so as to open an electrical circuit (50),
     -- an elastic member (7) linked to the driving element (9),
     -- an unlocking member (8) configured to pass from a locking position (V) wherein the elastic member (7) is kept in a state of tension to a release position (L) wherein the elastic member (7) is free to relax so as to move the electrical contact (10) from the closing position (F) to the opening position (O) of the electrical circuit (50) or from the opening position (O) to the closing position (F),

   - an actuator (1) configured to move the unlocking member (8) from the locking position (V) to the release position (L),

   the method comprising the steps of:

   (i) controlling the actuator (1) so as to move the unlocking member (8) from the locking position (V) to the release position (L),

   **characterised in that** the method furthermore comprises the steps of:

   (ii) determining a first instant (t1) corresponding to a predetermined position (P1) of the unlocking member (8),
   (iii) determining a second instant (t2) corresponding to a predetermined position (P2) of the driving element (9),
   (iv) determining a duration (D) elapsed between the first instant (t1) and the second instant (t2),
   (v) iterating steps (i) to (iii) for a set of successive commands of the actuator (1), so as to obtain a set (E) of values of the duration (D) elapsed between the first instant (t1) and the second instant (t2),
   (vi) determining a degradation of the unlocking member (8) of the switching device (30) from the evolution of the values of the set (E) in the course of the successive commands of the actuator (1).

2. The detection method according to claim 1, wherein the actuator (1) is an electromagnetic actuator, and wherein the method comprises the sub-steps of:

   - measuring a current (C) circulating in the electromagnetic actuator (1) during the actuation of the switching device (30),
   - determining the first instant (t1) corresponding to a predetermined position (P1) of the unlocking member (8) from the temporal variations of the measured current (C).

3. The detection method according to claim 2,

   wherein the electromagnetic actuator (1) comprises a control coil (2) and a magnetic core (3) configured to move under the action of a magnetic field created by a circulation of electrical current in the control coil (2), and wherein the predetermined position (P1) of the unlocking member (8) corresponding to the first instant (t1) is a maximum displacement position of the magnetic core (3).

4. The detection method according to claim 2 or 3, wherein the first instant (t1) corresponding to a predetermined position (P1) of the unlocking member (8) is a instant (tm) corresponding to a local minimum value of the electrical current circulating in the electromagnetic actuator (1).

5. The detection method according to claim 1, wherein the actuator (1) comprises a push button (32) that can be manually actuated by an operator and wherein the unlocking member (8) comprises a position indicator (33), wherein the method comprises the sub-steps of:

   - measuring an electrical signal of the position indicator (33),

- determining the first instant (t1) corresponding to a predetermined position (P1) of the unlocking member (8) from the temporal variations of the electrical signal of the position indicator (33).

6. The detection method according to one of the preceding claims, wherein the predetermined position of the driving element (9) corresponding to the second instant (t2) is an intermediate displacement position of the driving element (9), the intermediate displacement position being between a first extreme position (B1) wherein the movable electrical contact (10) is in the closed position (F) and a second extreme position (B2) wherein the movable electrical contact (10) is in the opening position (O).

7. The detection method according to the preceding claim, wherein a displacement stroke of the driving element (9) between the first extreme position (B1) and the predetermined position (P2) corresponding to the second instant (t2) is comprised between 5% and 15% of a total displacement stroke (CT) of the driving element (9).

8. The detection method according to one of the preceding claims, comprising the substeps of:

   - measuring a position of the driving element (9) during the actuation of the switching device (30),
   - determining the second instant (t2) corresponding to the predetermined position (P2) of the driving element (9) from the measured position of the driving element (9).

9. The detection method according to one of the preceding claims, wherein:

   - the control mechanism (4) comprises a position sensor (14) configured to detect a magnetic field,
   - the driving element (9) comprises a plurality of magnetic elements (15) configured to pass successively in front of the position sensor (14) during a displacement stroke of the driving element (9).

10. The detection method according to one of the preceding claims, comprising the sub-step of:

   - calculating a value of a statistical parameter (P) representative of a fluctuation of the values of the set (E) of values of the duration (D) elapsed between the first instant (t1) and the second instant (t2),
   - determining a degradation of the unlocking member (8) from the calculated value of the statistical parameter (P).

11. The detection method according to the preceding claim, wherein the statistical parameter (P) representative of a fluctuation of the values of the set (E) of values of the duration (D) elapsed between the first instant (t1) and the second instant (t2) comprises a difference (X) between:

   - a current value of the duration (D) elapsed between the first instant (t1) and the second instant (t2), determined for a current actuation of the switching device (30), and
   - an average value (Moy) of the values of the duration (D) elapsed between the first instant (t1) and the second instant (t2) obtained for a predetermined number (M) of actuations preceding the current actuation of the switching device (30).

12. The detection method according to claim 10 or 11, wherein the statistical parameter (P) representative of a fluctuation of the values of the set (E) of values of the duration (D) elapsed between the first instant (t1) and the second instant (t2) comprises a standard deviation of the values of the duration (D) elapsed between the first instant (t1) and the second instant (t2) determined for a set of actuations of the switching device (30) carried out under reference conditions corresponding to a new condition of the circuit breaker (30).

13. The detection method according to one of claims 10 to 12, wherein the statistical parameter (P) representative of a fluctuation of the duration (D) elapsed between the first instant (t1) and the second instant (t2) is equal to the ratio of:

   - the difference (X) between a current value (Di) of the duration (D) elapsed between the first instant (t1) and the second instant (t2) and the average value (Moy) of the values of the duration (D) elapsed between the first instant (t1) and the second instant (t2) obtained for a predetermined number (M) of actuations preceding the current actuation, and
   - the determined standard deviation of the values of the duration (D) elapsed between the first instant (t1) and the second instant (t2) determined for a set of actuations of the switching device (30) carried out under reference conditions corresponding to a new condition of the switching device (30).

14. The detection method according to one of claims 10 to 13, wherein the statistical parameter (P) representative of a fluctuation of the duration (D) elapsed between the first instant (t1) and the second instant (t2) is equal to:

[Math. 1]

$$P(i) = \frac{D_i - \frac{\sum_{j=i-M}^{j=i-1} D_j}{M}}{\sqrt{\sum_{j=1}^{N}\left(\frac{D_j - \frac{\sum_{j=1}^{j=N} D_j}{K}}{K}\right)^2}}$$

Where $D_i$ is the determined value of the duration D for an actuation of rank i,

P(i) is the calculated value of the statistical parameter P for the actuation of rank i,
M is the number of actuations taken into account in order to determine an average value,
K is the number of actuations carried out under reference conditions corresponding to a new condition of the switching device 30.

15. The detection method according to one of claims 10 to 14, wherein a degradation of the unlocking member (8) is determined when the absolute value of the statistical parameter (P) representative of a fluctuation of the duration (D) elapsed between the first instant (t1) and the second instant (t2) is greater than a first positive predetermined threshold (S1).

16. The method according to the preceding claim, wherein:

- the degradation of the unlocking member (8) is classified as a first type of degradation, referred to as minor degradation, when the absolute value of the statistical parameter (P) representative of a fluctuation of the duration (D) elapsed between the first instant (t1) and the second instant (t2) is greater than a first positive predetermined threshold (S1) and less than a second positive predetermined threshold (S2), and

wherein:

- the degradation of the unlocking member (8) is classified as a second type of degradation, referred to as major degradation, when the absolute value of the statistical parameter (P) representative of a fluctuation of the duration (D) elapsed between the first instant (t1) and the second instant (t2) is greater than the second positive predetermined threshold (S2).

17. The detection method according to claim 15 or 16, comprising a step of transmitting an alert signal in response to a determination of a degradation of the unlocking member (8).

18. A switching device (30) comprising:

- an electrical contact (10) movable between a closing position (F) of an electrical circuit (50) and an opening position (O) of the electrical circuit (50),
- a control mechanism (4) comprising:

-- a driving element (9) configured to move the movable electrical contact (10) so as to open an electrical circuit (50),
-- an elastic member (7) linked to the driving element (9),
-- an unlocking member (8) configured to pass from a locking position (V) wherein the elastic member (7) is kept in a state of tension to a release position (L) wherein the elastic member (7) is free to relax so as to move the electrical contact (10) from the closing position (F) to the opening position (O) of the electrical circuit (50),

- an actuator (1) configured to move the unlocking member (8) from the locking position (V) to the release position (L),
- an electronic control unit (25) configured to implement the method for detecting degradation according to one of the preceding claims, the switching device (30) being a circuit breaker, or a switch, or a disconnector.

[Fig. 1]

FIG. 1

[Fig. 2]

FIG. 2

[Fig. 3]

FIG. 3

[Fig. 4]

FIG. 4

[Fig. 5]

FIG. 5

[Fig. 6]

FIG. 6

[Fig. 7]

FIG. 7

[Fig. 8]

FIG. 8

[Fig. 9]

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7692522 B2